# EUROPEAN PATENT APPLICATION

(11) **EP 2 740 593 A1**
(43) Date of publication of application: **11.06.2014**
(21) Application number: 12817195.6
(22) Date of filing: 27.07.2012
(51) Int. Cl.: B32B 9/00, C23C 16/40, C23C 16/455

(54) **LAMINATE, GAS BARRIER FILM, PRODUCTION METHOD FOR LAMINATE, AND LAMINATE PRODUCTION DEVICE**

(30) Priority: 28.07.2011 JP 2011165903; 28.07.2011 JP 2011165904
(71) Applicant: Toppan Printing Co., Ltd., Tokyo 110-8560 (JP)
(72) Inventor: YOSHIHARA Toshiaki, Tokyo 110-8560 (JP); KUROKI Kyoko, Tokyo 110-8560 (JP); KANO Mitsuru, Tokyo 110-8560 (JP); SATO Jin, Tokyo 110-8560 (JP)
(74) Representative: Andrews, Timothy Stephen
(86) International application number: PCT/JP2012/069191
(87) International publication number: WO 2013/015417

(57) **Abstract**

A laminate body of the present invention includes a base material (2), an atomic layer deposition film (4) that is formed along the outer surface of the base material (2), and an overcoat layer (5) that covers the atomic layer deposition film (4) with a film having a mechanical strength higher than that of the atomic layer deposition film (4).

## Description

### TECHNICAL FIELD

The present invention relates to a laminate body in which an atomic layer deposition film is formed on the outer surface of a base material, a gas barrier film formed of the laminate body, a method of manufacturing a laminate body in which an atomic layer deposition film is formed on the outer surface of a base material, and a laminate body manufacturing apparatus for manufacturing the laminate body.

Priority is claimed on Japanese Patent Applications No. 2011-165903 and No. 2011-165904, filed July 28, 2011, the contents of which are incorporated herein by reference.

### BACKGROUND ART

Methods of forming a thin film on the surface of a substance using a gaseous phase that makes a substance move at an atomic/molecular level similar to gas are roughly classified into Chemical Vapor Deposition (CVD) and Physical Vapor Deposition (PVD).

Typical methods of PVD include vacuum deposition, sputtering, and the like. Particularly, with sputtering, a high-quality thin film having excellent uniformity of film quality and film thickness can be formed in general, even though the cost of the apparatus is high. Therefore, this method is being widely applied to display devices such as a liquid crystal display.

CVD is a method of injecting raw material gas into a vacuum chamber and decomposing or reacting one, two, or more kinds of gases on a substrate by means of heat energy to grow a thin solid film. At this time, in order to accelerate the reaction during the film formation or to decrease the reaction temperature, sometimes a plasma or catalyst reaction is concurrently used, and such a method is called Plasma-Enhanced CVD (PECVD) or Cat-CVD respectively. Such CVD features a small degree of film formation defectiveness and is mainly applied to a manufacturing process of semiconductor devices, such as formation of a gate-insulating film.

In recent years, Atomic Layer Deposition (ALD) has drawn attention. ALD is a method in which a substance adsorbed onto a substrate surface is formed into films layer-by-layer at an atomic level by means of a chemical reaction caused on the surface, and is categorized as a CVD process. A difference between ALD and general CVD is that the so-called CVD (a general CVD) grows thin films by reacting a single gas on a substrate or by simultaneously reacting a plurality of gases on a substrate. On the other hand, ALD is a special film formation method that alternately uses highly-active gas which is called Tri-Methyl Aluminum (TMA) or a precursor and a reactive gas (also called a precursor in ALD) to grow thin films layer-by-layer at an atomic level by means of adsorption caused on the substrate surface and a chemical reaction following the adsorption.

Specifically, a film is formed as follows by ALD. During the surface adsorption caused on the substrate surface, if the surface is covered with a certain type of gas, a so-called self-limiting effect by which the gas is no longer being adsorbed is utilized to discharge unreacted precursors at a point in time when the precursors have been adsorbed onto only one layer. Thereafter, a reactive gas is injected to oxidize or reduce the above precursors and to obtain only one layer of a thin film having a desired composition, and then the reactive gas is discharged. The above treatment is regarded as one cycle, and this cycle is repeated to grow thin films. Accordingly, in an ALD process, thin films grow in a two-dimensional manner. Needless to say, a degree of film formation defectiveness is smaller in the ALD process than in the conventional vacuum deposition, sputtering, and the like than in the general CVD process and the like, and this is the feature of ALD. Consequently, ALD is expected to be widely applied to various fields including the fields of packing foods, pharmaceutical products or electronic parts.

ALD also includes a method that uses plasma for enhancing a reaction in a step of decomposing second precursors and reacting these with a first precursor having been adsorbed onto the substrate. This method is called Plasma-Enhanced ALD (PEALD) or simply called plasma ALD.

The technique of ALD was proposed by Dr. Tuomo Sumtola from Finland in 1974. Generally, since a high-quality and high-density film can be formed by ALD, this method is being increasingly applied to the field of semiconductors such as gate-insulating films, and International Technology Roadmap for Semiconductors (ITRS) also describes this method. Moreover, ALD has a feature in that this method does not provide an oblique shadow effect (a phenomenon in which sputtering particles obliquely enter the substrate surface and thus cause unevenness during film formation) compared to other film formation methods. Accordingly, a film can be formed as long as there is a space into which a gas is injected. Therefore, ALD is expected to be applied not only to coating films of lines and holes on a substrate having a high aspect ratio which indicates a high ratio between the depth and the width, but also to the field relating to Micro Electro Mechanical Systems (MEMS) for coating films of three-dimensional structures.

However, ALD also has faults. That is, for example, special materials are used to perform ALD, and accordingly, the cost increases. However, the biggest fault thereof is the slow film formation speed. For example, the film formation speed thereof is 5 to 10 times slower than that of general film formation methods such as vacuum deposition or sputtering.

As described above, a thin film formed by means of ALD using the above film formation methods can be applied to small plate-like substrates such as wafers or photomasks; inflexible substrates having a large area, such as glass plates; flexible substrates having a large area, such as films; and the like. Regarding equipment for mass-producing such thin films on these substrates according to the use thereof, various substrate-handling methods have been proposed according to the cost, ease of handleability, the quality of formed film, and the like, and have been put to practical use.

For example, a sheet-type film formation apparatus is known that forms a film for a wafer by a sheet of substrate being supplied to the apparatus and then forms a film again on the next substrate replaced, a batch-type film formation apparatus in which a plurality of substrates are set together such that the same film formation processing is performed on all the wafers, or the like.

In addition, regarding an example of forming a film on a glass substrate or the like, an inline-type film formation apparatus is known that forms a film while sequentially transporting substrates to a portion as a source of film formation. Moreover, a coating film formation apparatus is known using a so-called roll-to-roll process in which a substrate, which is mainly a flexible substrate, is wound off and transported from a roller to form a film and the substrate is wound around another roller. This apparatus also includes a web coating film formation apparatus that continuously forms a film by loading not only a flexible substrate but also a substrate on which a film is to be formed on a flexible sheet which can be continuously transported or on a tray of which a portion is flexible.

Regarding the film formation methods or substrate-handling methods used by any of the film formation apparatuses, a combination of the film formation apparatuses that yields the highest film formation speed is employed in consideration of the cost, quality, or ease of handleability.

Moreover, as a related technique, a technique of performing ALD to form a gas permeation barrier layer on a plastic substrate or a glass substrate has been disclosed (for example, see Patent Document 1). According to this technique, a light-emitting polymer is loaded on a plastic substrate having flexibility and light permeability, and ALD (top coating) is performed on the surface and the lateral surface of the light-emitting polymer. As a result, it is possible to reduce coating defectiveness, and a light-permeable barrier film that can substantially reduce a degree of gas permeation in a thickness of tens-of-nanometers can be realized.

Further, as another related technique, a technique relating to a barrier layer-processing apparatus for forming a barrier layer on a substrate by means of ALD has been disclosed (for example, see Patent Document 2). According to this technique, during the process of loading a film-like substrate on a conveyer and moving the substrate by causing the substrate to penetrate a vacuum chamber, an atomic layer deposition film is formed on the surface of the substrate loaded on the conveyer. The film-like substrate, on which the atomic layer deposition film has been formed, is wound around a winding-up drum, whereby a film having a high degree of gas barrier properties is produced at a high speed.

### PRIOR ART DOCUMENTS

### PATENT DOCUMENTS

[Patent Document 1] Published Japanese Translation No. 2007-516347 of the PCT International Publication
[Patent Document 2] Published Japanese Translation No. 2007-522344 of the PCT International Publication

### DISCLOSURE OF INVENTION

### PROBLEMS TO BE SOLVED BY THE INVENTION

As described above, conventionally, laminate bodies in which an atomic layer deposition film is disposed on the outer surface of a base material (substrate) by means of ALD are known, and these laminate bodies are preferably used for gas barrier films and the like having gas barrier properties. However, the atomic layer deposition film is easily scratched by an external force or the like in some cases. When the atomic layer deposition film is scratched, sometimes through-holes extending in the thickness direction of the atomic layer deposition film are caused depending on the extent of the scratches. If through-holes are caused in the atomic layer deposition film in the film thickness direction, gas comes in and out through the through-holes, and accordingly, the gas barrier properties deteriorate.

Therefore, when a laminate body having an atomic layer deposition film which is easily scratched as described above is manufactured, if a production line which prevents a rigid substance from coming into contact with the atomic layer deposition film after the formation of the atomic layer deposition film is not used, the gas barrier properties deteriorate. Accordingly, for example, when a film-like laminate body (that is, a gas barrier film) is manufactured, the atomic layer deposition film on the surface of the base material may be scratched when the gas barrier film is wound up in a roll shape around a winding-up roller, and thus the gas barrier properties may deteriorate. That is, in the manufacturing process of the laminate body, if the gas barrier film is transported or stored by being wound up in a roll shape, this causes problems in terms of maintaining a high degree of gas barrier properties.

Regarding the barrier film disclosed in Patent Document 1, the document does not describe the manufacturing method. However, for example, when a film-like substrate (base material) is wound around a winding-up drum as in the technique disclosed in Patent Document 2, the atomic layer deposition film may be scratched as described above, hence a high degree of gas barrier properties are not easily maintained.

The present invention has been made in consideration of the above circumstances, and an object thereof is to provide a laminate body of which the gas barrier properties are improved by making an atomic layer deposition film formed on the outer surface of a base material not easily scratched by an external force, a gas barrier film formed of the laminate body, a method of manufacturing the laminate body, and a laminate body manufacturing apparatus for manufacturing the laminate body.

### MEANS FOR SOLVING THE PROBLEMS

A first aspect of the present invention is a laminate body including a base material, an atomic layer deposition film that is formed along the outer surface of the base material, and an overcoat layer that covers the atomic layer deposition film with a film having a mechanical strength higher than that of the atomic layer deposition film.

A second aspect of the present invention is a laminate body including a base material, an atomic layer deposition film formed along the outer surface of the base material, and an overcoat layer that covers the atomic layer deposition film with a film which has a mechanical strength equivalent to that of the atomic layer deposition film and has a thickness greater than that of the atomic layer deposition film.

The overcoat layer may be formed of an aqueous barrier coat.

The aqueous barrier coat may include at least either an OH group or a COOH group.

The aqueous barrier coat may include an inorganic substance.

The laminate bodies of the first and second aspects may further include, between the base material and the atomic layer deposition film, an undercoat layer in which an inorganic substance binding to the atomic layer deposition film has dispersed.

The laminate bodies of the first and second aspects further include, between the base material and the atomic layer deposition film, an undercoat layer including an organic polymer binding to the atomic layer deposition film.

A third aspect of the present invention is a gas barrier film including the laminate body of the first or second aspect, in which the laminate body has been formed into a film shape.

A fourth aspect of the present invention is a method of manufacturing a laminate body, including a first step of forming an atomic layer deposition film having a thin film shape along the outer surface of a base material; a second step of generating a laminate body by forming an overcoat layer which has a mechanical strength higher than that of the atomic layer deposition film along the outer surface of the atomic layer deposition film, in a line that is within the step serially connected to the first step, and a third step of storing the laminate body such that the overcoat layer formed by the second step comes into contact with a rigid substance.

A fifth aspect of the present invention is a method of manufacturing a laminate body, including a first step of forming an atomic layer deposition film having a thin film shape along the outer surface of a base material; a second step of generating a laminate body by forming an overcoat layer which has a mechanical strength equivalent to that of the atomic layer deposition film and has a film thickness greater than that of the atomic layer deposition film along the outer surface of the atomic layer deposition film, in a line that is within the step serially connected to the first step; and a third step of storing the laminate body such that the overcoat layer formed by the second step comes into contact with a rigid substance.

A sixth aspect of the present invention is a method of manufacturing a laminate body, including a first step of forming an undercoat layer that includes at least either an inorganic substance or an organic polymer along the outer surface of a base material; a second step of forming an atomic layer deposition film having a thin film shape along the outer surface of the undercoat layer such that the atomic layer deposition film binds to at least either the inorganic substance or the organic polymer exposed on the surface of the undercoat layer formed by the first step; a third step of generating a laminate body by forming an overcoat layer which has a mechanical strength higher than that of the atomic layer deposition film along the outer surface of the atomic layer deposition film, in a line that is within the step serially connected to the second step; and a fourth step of storing the laminate body such that the overcoat layer formed by the third step comes into contact with a rigid substance.

A seventh aspect of the present invention is a method of manufacturing a laminate body, including a first step of forming an undercoat layer that includes at least either an inorganic substance or an organic polymer along the outer surface of a base material; a second step of forming an atomic layer deposition film having a thin film shape on the outer surface of the undercoat layer such that the atomic layer deposition film binds to at least either the inorganic substance or the organic polymer exposed on the surface of the undercoat layer formed by the first step, a third step of generating a laminate body by forming an overcoat layer which has a mechanical strength equivalent to that of the atomic layer deposition film and has a film thickness greater than that of the atomic layer deposition film along the outer surface of the atomic layer deposition film, in a line that is within the step serially connected to the second step; and a fourth step of storing the laminate body such that the overcoat layer formed by the third step comes into contact with a rigid substance.

The rigid substance may be a winding-up roller, and during or after the third step, the laminate body may be stored by coming into contact with and being wound around the winding-up roller in a roll shape.

The overcoat layer may be an acryl film formed on the outer surface of the atomic layer deposition film by Vapor Deposition by flash evaporation.

The overcoat layer may be formed by chemical vapor deposition.

An eighth aspect of the present invention is a laminate body manufacturing apparatus that transports a laminate body in which an atomic layer deposition film has been formed on a windable web-like base material formed into a thin plate, a film, or a membrane shape by a roll-to-roll method in-line steps, the apparatus including a support that supports one surface of the base material in the thickness direction; a transport mechanism that transports the base material in one direction along the outer surface of the support; ALD film formation portions that are disposed to make the base material inserted between these portions and the outer surface of the support and form the atomic layer deposition film on the other surface of the substrate in the thickness direction; an overcoat formation portion that is disposed downstream of the ALD film formation portions in the transport direction of the substrate and forms an overcoat layer which has a mechanical strength higher than that of the atomic layer deposition film and has a film thickness greater than that of the atomic layer deposition film on the surface of the atomic layer deposition film; and a winding-up mechanism that is disposed downstream of the overcoat formation portion in the transport direction of the substrate and winds up the laminate body in a roll shape using the overcoat layer as a contact surface.

The overcoat formation portion may form the overcoat layer by Vapor Deposition by flash evaporation or chemical vapor deposition.

The laminate body manufacturing apparatus of the eighth aspect may further include an undercoat formation portion that is disposed upstream from the ALD film formation portion in the transport direction of the base material, and the undercoat formation portion may form an undercoat layer that has binding sites binding to the atomic layer deposition film on the outer surface of the base material.

### EFFECTS OF THE INVENTION

The laminate body and the gas barrier film of the present invention have a high degree of gas barrier properties. Moreover, the method of manufacturing a laminate body and the laminate body manufacturing apparatus of the present invention can easily manufacture a laminate body having a high degree of gas barrier properties.

### BRIEF DESCRIPTION OF THE DRAWINGS

FIG. 1 is a cross-sectional view showing the structure of a laminate body according to the first embodiment of the present invention.
FIG. 2 is a cross-sectional view showing the structure of a laminate body according to the second embodiment of the present invention.
FIG. 3 is a view comparing a laminate body with an overcoat layer of the present example with a laminate body without an overcoat layer of a comparative example, in terms of a water vapor transmission rate.
FIG. 4 is a schematic structural view of a laminate body manufacturing apparatus which is applied to the third embodiment of the present invention and forms an overcoat layer by Vapor Deposition by flash evaporation.
FIG. 5 is a schematic structural view of a laminate body manufacturing apparatus which is applied to the fourth embodiment of the present invention and forms an overcoat layer by CVD.
FIG. 6 is a flowchart illustrating a summary of a laminate body manufacturing process that is performed when an undercoat layer is not formed in an embodiment of the present invention.
FIG. 7 is a flowchart illustrating a summary of a laminate body manufacturing process that is performed when an undercoat layer is formed in an embodiment of the present invention.
FIG. 8 is a view comparing a laminate body with an overcoat layer of the present example with a laminate body without an overcoat layer of a comparative example, in terms of a Water Vapor Transmission Rate (WVTR).

### EMBODIMENTS FOR CARRYING OUT THE INVENTION

### «Summary of Embodiments»

The laminate body according to the embodiments of the present invention basically has a structure in which an atomic layer deposition film is formed on the surface of a substrate, and an overcoat layer is formed to cover the surface of the atomic layer deposition film. The overcoat layer may be a layer having any types of properties as long as it does not deteriorate the properties of the base material or the ALD film. Moreover, the magnitude of an external force required to form through-holes in the overcoat layer that extend in the film thickness direction needs to be greater than the magnitude of an external force required to form through-holes in the ALD film that extend in the film thickness direction. In other words, the overcoat layer needs to be a layer having a mechanical strength higher than that of the atomic layer deposition film. Alternatively, when the overcoat layer has a mechanical strength equivalent to that of the atomic layer deposition film, the overcoat layer needs to be a layer formed of a film having a film thickness greater than that of the atomic layer deposition film.

In the laminate body according to the embodiments of the present invention, an undercoat layer may be disposed between the base material and the atomic layer deposition film. That is, the laminate body may have a structure in which the undercoat layer is formed on the surface of the base material, the atomic layer deposition film is formed on the surface of the undercoat layer, and an overcoat layer is formed to cover the surface of the atomic layer deposition film.

### «First Embodiment»

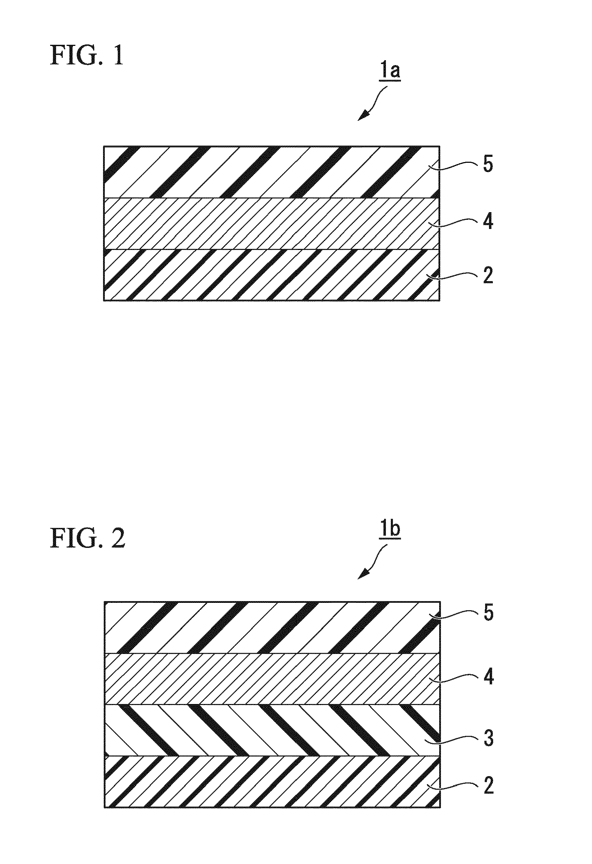

FIG. 1 is a cross-sectional view showing the structure of a laminate body according to the first embodiment of the present invention. As shown in FIG. 1, a laminate body 1a of the first embodiment is constituted of a base material 2 formed of a polymer material, an atomic layer deposition film (hereinafter, called an ALD film) 4 having a film shape that is formed on the surface of the base material 2, and an overcoat layer (hereinafter, called an OC layer) 5 that covers the ALD film 4 with a film having a mechanical strength higher than that of the ALD film 4. The OC layer 5 may cover the ALD film 4 with a film which has a mechanical strength equivalent to that of the ALD film 4 and has a film thickness greater than that of the ALD film 4.

That is, if the OC layer 5 with a mechanical strength higher than that of the ALD film 4 is formed on the surface of the ALD film 4, even if an external force of such a magnitude that may scratch the ALD film 4 and form through-holes in the film thickness direction is applied, through-holes may not be formed in the OC layer 5 in the film thickness direction by such an external force. Accordingly, if the OC layer 5 is formed on the surface of the ALD film 4, gas barrier properties of the laminate body 1a can be improved. Moreover, when the OC layer 5 having a mechanical strength equivalent to that of the ALD film 4 is formed, if the OC layer 5 is formed of a film having a film thickness greater than that of the ALD film 4, even if the ALD film 4 is scratched, and through-holes are formed in the film thickness direction, the through-holes may not be formed in the OC layer 5 in the film thickness direction by such an external force. Therefore, gas barrier properties of the laminate body 1a can be improved.

The OC layer 5 is formed of an aqueous barrier coat, and functional groups of the aqueous barrier coat have an OH group or a COOH group. The OC layer 5 may also include an inorganic substance. The aqueous barrier coat refers to a coating film having barrier properties that is formed of an aqueous organic polymer, a hydrolysis polymer formed of an organic metal compound such as a metal alkoxide or a silane coupling agent, and complexes of these. Examples of the aqueous organic polymer include polyvinyl alcohol, polyacrylic acid, polyethyleneimide, and the like.

Examples of the organic metal compound include a metal alkoxide which is represented by a general formula R1(M-OR2). Here, R1 and R2 are organic groups having 1 to 8 carbon atoms, and M is a metal atom. The metal atom M includes Si, Ti, Al, Zr, and the like.

Examples of compounds which include Si as the metal atom M and are represented by R1(Si-OR2) include tetramethoxysilane, tetraethoxysilane, tetrapropoxysilane, tetrabutoxysilane, methyltrimethoxysilane, methyltriethoxysilane, dimethyldimethoxysilane, dimethyldiethoxysilane, and the like.

Examples of compounds which include Zr as the metal atom M and are represented by R1(Zr-OR2) include tetramethoxyzirconium, tetraethoxyzirconium, tetraisopropoxyzirconium, tetrabutoxyzirconium, and the like.

Examples of compounds which include Ti as the metal atom M and are represented by R1(Ti-OR2) include tetramethoxytitanium, tetraethoxytitanium, tetraisopropoxytitanium, tetrabutoxytitanium, and the like.

Examples of compounds which include Al as the metal atom M and are represented by R1(Al-OR2) include tetramethoxyaluminum, tetraethoxyaluminum, tetraisopropoxyaluminum, tetrabutoxyaluminum, and the like.

When the inorganic substance is made into inorganic particles, among candidates of the materials, halloysite, calcium carbonate, silicic anhydride, hydrous silicic acid, alumina, and the like which have a particle size larger than that of candidates of extender pigments, for example, kaolinite as a type of viscous mineral are exemplified as inorganic compounds. In addition, when the inorganic substance is made into a layered compound, examples thereof include artificial clay, fluorphlogopite, fluorine-4-silicon mica, taeniolite, fluorine vermiculite, fluorine hectolite, hectolite, sapolite, stevensite, montmorillonite, beidellite, kaolinite, fraipontite, and the like.

As layered viscous minerals, inorganic substances such as pyrophyllite, talc, montmorillonite (overlapped with artificial clay), beidellite, nontronite, saponite, vermiculite, sericite, glauconite, celadonite, kaolinite, nacrite, dickite, halloysite, antigorite, chrysotile, amesite, cronstedtite, chamosite, chlorite, allevardite, corrrensite, and tosudite can be used as layered compounds.

Inorganic particles (spherical particles) other than extender pigments include metal oxides such as zirconia and titania as polycrystalline compounds, metal oxides which are represented by a general chemical formula MM'O_{X} or the like and include two or more kinds of metal atoms (M, M', ...), such as barium titanate and strontium titanate, and the like.

### «Second Embodiment»

FIG. 2 is a cross-sectional view showing the structure of a laminate body according to the second embodiment of the present invention. As shown in FIG. 2, a laminate body 1b of the second embodiment differs from the laminate body 1a of the first embodiment shown in FIG. 1 in that an undercoat layer (hereinafter, called a UC layer) 3 is interposed between the base material 2 and the ALD film 4. The UC layer 3 may include either an inorganic substance or an organic polymer.

That is, the laminate body 1b is constituted of the base material 2 formed of a polymer material, the UC layer 3 that is formed on the surface of the base material 2 and has a shape of a membrane or a film, the ALD film 4 that is formed on the surface opposite to the surface which comes into contact with the base material 2 among both surfaces of the UC layer 3 in the thickness direction thereof, and the OC layer 5 that covers the ALD film 4 with a film having a mechanical strength higher than that of the ALD film 4. The OC layer 5 may cover the ALD film 4 with a film which has a mechanical strength equivalent to that of the ALD film 4 and has a film thickness greater than that of the ALD film 4. Herein, the UC layer 3 includes the inorganic substance in some cases and includes the organic polymer in some cases, so those cases will each be described.

### «UC Layer Including Inorganic Substance»

As shown in FIG. 2, in the laminate body 1b, the UC layer 3 in which the inorganic substance has dispersed is disposed between the base material 2 and the ALD film 4, and the OC layer 5 is formed on the surface of the ALD film 4. The precursors of the ALD film 4 are gaseous substances and have a property of easily binding to the inorganic substance exposed on the surface of the UC layer 3. Moreover, since a large number of inorganic substances are exposed on the surface of the UC layer 3, the precursors of the ALD film 4 that have bound to the respective inorganic substances bind to one another. Therefore, a two-dimensional ALD film 4 growing in the surface direction of the UC layer 3 is formed. As a result, a space that allows gas to permeate in the film thickness direction of the laminate body 1b is not easily formed, whereby the laminate body 1b having a high degree of gas barrier properties can be realized.

That is, in order to realize (1) improvement of the density of adsorption sites of the precursors of the ALD film 4 and (2) prevention of the precursors of the ALD film 4 from diffusing to the polymeric base material 2, the UC layer 3 including the inorganic substance is disposed on the polymeric base material 2. In other words, in order to two-dimensionally dispose the adsorption sites of the precursors of the ALD film 4 on the surface of the polymeric base material 2 at a high density, the UC layer 3 including the inorganic substance is disposed on the polymeric base material 2 before the ALD process is performed. Moreover, in order to increase the density of the adsorption sites of the precursors of the ALD film 4, adsorption sites of the inorganic substance having a high density are used. If the UC layer 3 including the inorganic substance (inorganic compound) is disposed on the polymeric base material 2 in this manner, gas including the precursors cannot permeate the inorganic substance of the UC layer 3.

As described above, the laminate body 1b of the second embodiment includes, as shown in FIG. 2, the base material 2 formed of a polymer material, the UC layer 3 that is formed on the surface of the base material 2 and has a shape of a membrane or film, the ALD film 4 that is formed on the surface opposite to the surface which comes into contact with the base material 2 among both surfaces of the UC layer 3 in the thickness direction thereof, and the OC layer 5 that is formed on the ALD film 4. Furthermore, the UC layer 3 has a structure in which the inorganic substance (inorganic material) has been added to a binder. That is, the precursors of the ALD film 4 bind to the inorganic substance included in the UC layer 3 and are formed into a membrane shape such that the ALD film 4 covers the UC layer 3.

Herein, the properties of the UC layer 3 will be described. The UC layer 3 is formed of a binder and the inorganic substance (inorganic material). At this time, unlike a polymer, the inorganic substance has a small free volume. In addition, since the inorganic substance does not have a glass transition as the polymer does, the properties thereof do not change even in a high-temperature process. That is, an amorphous portion of the polymer starts to exhibit Brown movement at a temperature equal to or higher than a glass transition thereof, and the gas diffusion speed increases in the free volume. However, in the inorganic substance, such a phenomenon caused by the glass transition temperature is not observed.

The inorganic substance used for the UC layer 3 is a layered compound. Accordingly, such an inorganic substance as a layered compound is aligned approximately in parallel with the coating surface of the base material 2. In addition, during ALD, all the gas including the precursors cannot diffuse to the inside of the inorganic substance as a layered compound.

Moreover, in order to make the surface of the inorganic substance as a layered substance exposed, the surface of the UC layer 3 is etched. That is, plasma treatment is performed to introduce desired functional groups into the surface of the inorganic substance as a layered compound in the UC layer 3 exposed on the base material 2, whereby the surface of the UC layer 3 is etched. This makes it easy for the precursors of the ALD film 4 to bind to the inorganic substance of the UC layer 3.

When the UC layer 3 having the above properties is disposed on, for example, the surface of the polymeric base material 2, the adsorption sites of the precursors are disposed at a high density on the surface of the base material 2. Furthermore, the inorganic substance as a layered compound in the UC layer 3 is disposed in parallel with the surface of the base material 2. Consequently, since the UC layer 3 virtually uniformly covers the surface area of the base material 2, the adsorption sites are two-dimensionally disposed, whereby two-dimensional growth of the ALD film 4 is promoted. Moreover, in the UC layer 3, even when the process temperature of ALD for forming the ALD film 4 becomes high, the portion of the inorganic substance as a layered compound does not experience glass transition as a general plastic polymer does, hence the ALD film 4 stably grows.

The binder of the UC layer 3 may be any of an organic binder, an inorganic binder, and a hybrid binder as a mixture of organic and inorganic binders.

According to the laminate body 1b constituted as above, the inorganic substance as a layered compound is exposed on the surface of the UC layer 3 facing the ALD film 4. Therefore, the precursors of the ALD film 4 bind to the outer surface of the inorganic substance. Particularly, if the inorganic substance is formed into particles or a layered structure, a binding force of the ALD film 4 with respect to the precursors can be strengthened. Moreover, it is preferable to form the inorganic substance into a gel or a gel-like polymer to obtain an optimal binding force.

In addition, according to the laminate body 1b of the present embodiment, functional groups are disposed on the surface at a high density. Therefore, a dense and thin film can be expected to be formed not only by ALD but also by other thin film growth methods (for example, vacuum deposition, sputtering, and CVD) in a growth mode that yields a high nuclear density.

Next, the inorganic compound (inorganic substance) used for the UC layer 3 will be described in detail. The inorganic substance is carefully selected in consideration of the following points. That is, factors for selecting the inorganic substance formed of inorganic particles include the shape of the inorganic particles. There may be particles having a shape close to a spherical shape or a plate-like shape, but any particles can be used.

Regarding a particle size (particle diameter) of the inorganic particles, an average particle diameter thereof is set to be 1 µm or less and more preferably 0.1 µm or less so as not to influence the smoothness of the base material 2. Moreover, it is desirable that the size of the inorganic particles be sufficiently smaller than the wavelength of visible rays so as not to exert influence on the optical properties (that is, light transmittance, haze: ratio of light of diffuse transmittance to the light of total transmittance) of the UC layer 3 as much as possible. When the inorganic substance is a layered compound, a compound having an aspect ratio (Z) of 50 or higher and a thickness of 20 nm or less is selected. Here, provided that L is an average particle diameter, and a is a thickness of a material of the inorganic particles, Z = L/a.

Regarding the optical properties of the inorganic particles, in terms of coating a transparent barrier, it is not preferable for the particles to be colored. Particularly, for the UC layer 3, a refractive index of the binder needs to match a refractive index of the inorganic particles. That is, in the UC layer 3, if there is a significant difference between refractive indices of the binder and the inorganic particles, light is reflected to a large extent from the interface of the UC layer 3, and this leads to the decrease in the light transmittance or the increase in the haze (cloudy condition) in the UC layer 3.

Regarding dispersibility of the inorganic particles, secondary aggregation does not easily occur since the particles disperse excellently in the binder. When the inorganic substance is a layered compound, affinity (intercalation: chemical binding) with the binder is excellent.

Regarding stability of the inorganic particles, if the laminate body 1b is used as a solar cell, the laminate body 1b is assumed to be used for 20 to 30 years, hence the inorganic substance needs to be chemically stable even if the laminate body 1b is used for a long time at a high temperature, a high humidity, and an very low temperature. Further, regarding safety of the inorganic substance, the substance should not cause environmental harm at various stages including the manufacturing process of the laminate body 1b, usage time thereof, and disposal treatment thereof.

Next, the type of the inorganic substance added to the UC layer 3 will be described. When the inorganic substance used for the UC layer 3 is made into inorganic particles, among candidates of the materials, halloysite, calcium carbonate, silicic anhydride, hydrous silicic acid, alumina, and the like which have a particle diameter larger than that of candidates of extender pigments, for example, kaolinite as a type of viscous mineral are exemplified as the inorganic substance. In addition, when the inorganic substance is made into a layered compound, examples thereof include artificial clay, fluorphlogopite, fluorine-4-silicon mica, taeniolite, fluorine vermiculite, fluorine hectolite, hectolite, sapolite, stevensite, montmorillonite, beidellite, kaolinite, fraipontite, and the like.

As layered viscous minerals, inorganic substances such as pyrophyllite, talc, montmorillonite (overlapped with artificial clay), beidellite, nontronite, saponite, vermiculite, sericite, glauconite, celadonite, kaolinite, nacrite, dickite, halloysite, antigorite, chrysotile, amesite, cronstedtite, chamosite, chlorite, allevardite, corrrensite, and tosudite can be used as the layered compound.

Inorganic particles (spherical particles) other than extender pigments include metal oxides such as zirconia and titania as polycrystalline compounds, metal oxides which are represented by a general chemical formula MM'O_{X} or the like and include two or more kinds of metal atoms (M, M', ...), such as barium titanate and strontium titanate, and the like.

### <UC Layer Including Organic Polymer>

As shown in FIG. 2, in the laminate body 1b, the UC layer 3 including an organic polymer is disposed between the base material 2 and the ALD film 4, and the OC layer 5 is formed on the surface of the ALD film 4. The UC layer 3 is a layer including an organic polymer, and this organic polymer has binding sites to which the precursors of the ALD film 4 bind. That is, the organic polymer included in the UC layer 3 has a large number of functional groups, as binding sites that can easily bind to the precursors of the ALD film 4. Accordingly, the precursors having bound to the respective functional groups of the organic polymer bind to one another. Therefore, a two-dimensional ALD film 4 growing in the surface direction of the UC layer 3 is formed. As a result, a space that allows gas to permeate in the film thickness direction of the laminate body 1b is not easily formed, whereby the laminate body 1b having a high degree of gas barrier properties can be realized. Further, in addition to the organic polymer, the inorganic substance may disperse in the UC layer 3. That is, if the inorganic substance is added to the UC layer 3, the organic polymer is combined with the inorganic substance, whereby the adsorption density of the precursors of the ALD film 4 can be further improved.

In other words, in order to realize (1) improvement of the density of adsorption sites of the precursors of the ALD film 4 and (2) prevention of the precursors of the ALD film 4 from diffusing to the polymeric base material, the UC layer 3 including the organic polymer may be disposed on the polymeric base material 2. In this way, the UC layer 3 includes an organic polymer material and secures the adsorption sites of the precursors of the ALD film 4. That is, the organic polymer included in the UC layer 3 has functional groups onto which the precursors of the ALD film 4 are easily adsorbed. Accordingly, the precursors of the ALD film 4 bind to the functional groups of the organic polymer included in the UC layer 3, whereby the ALD film is formed into a membrane shape for covering the UC layer 3.

That is, as shown in FIG. 2, the laminate body 1b includes the base material 2 formed of a polymer material, the UC layer 3 that is formed on the surface of the base material 2 and has a shape of a membrane or a film, the ALD film 4 that is formed on the surface opposite to the surface which comes into contact with the base material 2 among both surfaces of the UC layer 3 in the thickness direction thereof, and the OC layer 5 that covers the surface of the ALD film 4. The UC layer 3 includes an organic polymer material and secures adsorption sites of the precursors of the ALD film 4. The organic polymer included in the UC layer 3 has functional groups onto which the precursors of the ALD film 4 are easily adsorbed. Accordingly, the precursors of the ALD film 4 bind to the functional groups of the organic polymer included in the UC layer 3, whereby the ALD film is formed into a membrane shape for covering the UC layer 3.

In order to secure the adsorption sites on the base material 2 using the organic polymer included in the UC layer 3, it is necessary to select an organic polymer having functional groups onto which the precursors of the ALD film 4 are easily adsorbed, and to select an organic polymer in which the density of the functional groups is high. Moreover, it is desirable to perform surface treatment on the base material 2 by plasma treatment or hydrolytic treatment such that a high density of the functional groups of the organic polymer is realized by means of modifying the surface of the organic polymer. At this time, it is also possible to further increase the adsorption density of the precursors by adding the inorganic compound to the organic polymer.

Further, for the UC layer 3, it is necessary to select a material including an organic polymer having functional groups onto which the precursors of the ALD film 4 are easily adsorbed. For example, when nylon-6 is used as a material of the organic polymer of the UC layer 3, since the functional groups thereof are amide groups, the precursors are highly and easily adsorbed onto the functional groups. Consequently, nylon-6 is desirable as a material of the organic polymer used for the UC layer 3. On the other hand, for the UC layer 3 it is not preferable to use polypropylene (PP) or the like, which has methyl groups onto which the precursors are not easily adsorbed.

That is, if PP having functional groups (methyl groups) onto which the precursors of the ALD film 4 are not easily adsorbed is used for the undercoat, since the adsorptivity of the precursors of the ALD film to PP is low, the density of the ALD film in the boundary between this film and the polymer decreases, whereby the gas barrier properties deteriorate. On the other hand, if nylon-6 having functional groups (amide groups) onto which the precursors of the ALD film are easily adsorbed is used for the undercoat, since the adsorptivity of the precursors of the ALD film to the nylon-6 is high, the density of the ALD film in the boundary between this film and the polymer increases, whereby the gas barrier properties are improved.

The materials of the organic polymer having functional groups onto which the precursors of the ALD film 4 are easily adsorbed also include, in addition to the above materials, a urethane resin having isocyanate groups, a polyimide resin having imide groups, polyester sulfone (PES) having sulfone groups, polyethylene terephthalate (PET) having ester groups, and the like.

That is, it is desirable for the functional groups of the organic polymer included in the UC layer 3 to have an O atom or an N atom. The functional groups having an O atom include OH groups, COOH groups, COOR groups, COR groups, NCO groups, SO₃ groups, and the like. Moreover, the functional groups having an N atom include NH_{X} groups (X is an integer).

The organic polymers used for the UC layer 3 are classified into aqueous organic polymers and solvent-based organic polymers depending on the type of solvent to be used. Examples of the aqueous organic polymers include polyvinyl alcohol, polyethylenimine, and the like. Examples of the solvent-based organic polymers include acrylic ester, urethane acryl, polyester acryl, polyether acryl, and the like.

Next, more specific examples of the organic polymer used for the UC layer 3 will be described.

### 1. Organic Polymer of O Atom-including Resin

The following materials are preferable as the organic polymer of an O atom-including resin. As hydroxyl group (OH) group-including resins, there are polyvinyl alcohol, phenol resins, polysaccharide, and the like. The polysaccharide includes cellulose, cellulose derivatives such as hydroxymethyl cellulose, hydroxyethyl cellulose, and carboxymethyl cellulose, chitin, chitosan, and the like. Moreover, as carbonyl group (COOH)-including resins, a carboxyvinyl polymer and the like are also preferable materials.

The organic polymer of an O atom-including resin other than the above includes polyketone, polyether ketone, polyether ether ketone, aliphatic ketone, and the like of a ketone group (CO)-including resin. In addition, a polyester resin, a polycarbonate resin, a liquid crystal polymer, polyethylene terephthalate (PET), polybutylene terephthalate (PBT), polyethylene naphthalate (PEN), polybutylene naphthalate (PBN), polytrimethylene terephthalate (PTT), and the like of an ester group (COO)-including resin can also be used. Moreover, an epoxy-based resin, an acrylic resin, and the like including the above functional groups may be used.

### 2. Organic Polymer of N Atom-including Resin

The following materials are preferable as the organic polymer of an N atom-including resin. The materials include polyimide, polyetherimide, polyamideimide, alicyclic polyimide, solvent-soluble polyimide, and the like of an imide group (CONHCO)-including resin. Regarding the alicyclic polyimide, though aromatic polyimide is generally obtained from an aromatic tetracarboxylic acid anhydride and an aromatic diamine, this type of polyimide does not have transparency. Therefore, in order to obtain transparent polyimide, an acid dianhydride or a diamine can be substituted with an aliphatic or alicyclic group. Alicyclic carboxylic acid includes 1,2,4,5-cyclohexane tetracarboxylic acid, 1,2,4,5-cyclopentane tetracarboxylic dianhydride, and the like. The solvent-soluble polyimide includes γ-butyrolactone, N,N-dimethylacetamide, N-methyl-2-pyrrolidone, and the like.

Preferable materials of the organic polymer of an N atom-including resin include nylon-6, nylon-6,6, a meta-xylene diamine-adipic acid polycondensate, polymethyl methacrylimide, and the like of an amide group (NHCO)-including resin. The materials also include a urethane resin of an isocyanate group (NHCOO)-including resin and the like. The urethane resin can also be used as an adhesive layer. In addition, an amino group (NH)-including resin can also be used.

### 3. Organic Polymer of S Atom-including Resin

The following materials can be used as the organic polymer of an S atom-including resin. That is, the materials include polyether sulfone (PES), polysulfone (PSF), polyphenyl sulfone (PPS), and the like of a sulfonyl group (SO₂)-including resin. Among these, PES and PSF are materials having a high degree of heat resistance. Moreover, a polymer alloy, a polybutylene terephthalate-based polymer alloy, polyphenylene sulfide-based polymer alloy, and the like can be used as the organic polymer. The polymer alloy may optionally make the above polymers into a polymer complex (alloy, blend, or composite).

### «EXAMPLES»

Next, specific examples of the laminate body which is realized based on the above embodiments and includes the overcoat layer will be described. First, a general film formation method of a gas barrier layer formed of an ALD film will be described. Herein, an ALD film formation method at the time when a UC layer has been formed on the surface of the base material will be described.

### <Film Formation Method of Gas Barrier Layer Formed of ALD Film>

### 1. Formation of Al₂O₃ Film

First, on the upper surface a polymer substrate or on the upper surface of a UC layer disposed on a polymer substrate, an Al₂O₃ film is formed by Atomic Layer Deposition (ALD). At this time, Trimethyl Aluminum (TMA) is used as raw material gas. In addition, O₂ and N₂ as process gas, O₂ and N₂ as purge gas, and O₂ as reactant gas-cum-plasma discharge gas are each supplied into a film formation chamber, simultaneously with the raw material gas. A treatment pressure at this time is controlled to be 10 Pa to 50 Pa. Moreover, as a power source for exciting plasma gas, a power source of 13.56 MHz is used, and plasma discharge is performed in an Inductively-Coupled Plasma (ICP) mode.

TMA and the process gas are supplied for 60 msec, the purge gas is supplied for 10 sec, and the reactant gas-cum-discharge gas is supplied for 5 sec. Further, while the reactant gas-cum-discharge gas is being supplied, plasma discharge is caused in an ICP mode. At this time, the output power of plasma discharge is controlled to be 250 W. Moreover, in order to perform gas purging after the plasma discharge, O₂ and N₂ as purge gas are supplied for 10 sec. The film formation temperature at this time is controlled to be 90°C.

The Al₂O₃ film formation speed under the above cycle conditions is as follows. That is, since a unit film formation speed is 1.4 Å/cycle to 1.5 Å/cycle, when a film having a thickness of 10 nm is formed by performing 70 cycles of film formation treatment, about 30 minutes is taken in total for forming the film.

### 2. Formation of TiO₂ Film

First, on the upper surface of a polymer substrate or on the upper surface of a UC layer disposed on a polymeric base material, a TiO₂ film is formed by ALD. At this time, titanium tetrachloride (TiCl₄) is used as raw material gas. In addition, N₂ as process gas, N₂ as purge gas, and O₂ as reactant gas-cum-plasma discharge gas are each supplied into a film formation chamber, simultaneously with the raw material gas. A treatment pressure at this time is controlled to be 10 to 50 Pa. Moreover, as a power source for exciting plasma gas, a power source of 13.56 MHz is used, and plasma discharge is performed in an ICP mode.

TiCl₄ and the process gas are supplied for 60 msec, the purge gas is supplied for 10 sec, and the reactant gas-cum-discharge gas is supplied for 3 sec. Further, while the reactant gas-cum-discharge gas is being supplied, plasma discharge was caused in an ICP mode. At this time, the output power of plasma discharge is controlled to be 250 W. Moreover, in order to perform gas purging after the plasma discharge, O₂ and N₂ as purge gas are supplied for 10 sec. The film formation temperature at this time is controlled to be 90°C.

The TiO₂ film formation speed under the above cycle conditions is as follows. That is, since a unit film formation speed is 0.9 Å/cycle, when a film having a thickness of 10 nm is formed by performing 110 cycles of film formation treatment, about 43 minutes is taken in total for forming the film.

### <Water Vapor Transmission Rate of Overcoat Layer>

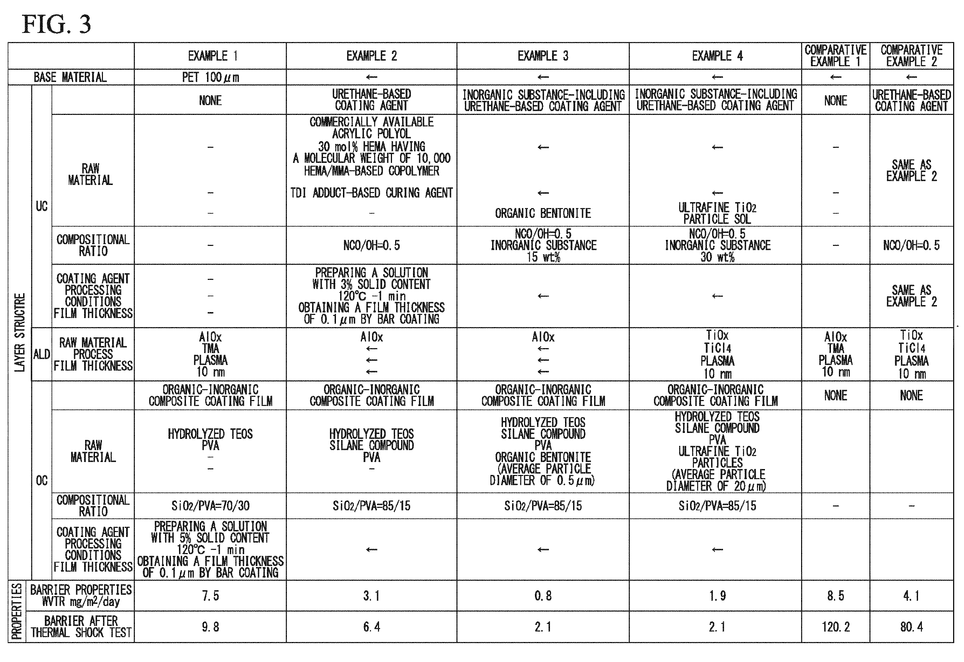

Next, regarding experimental results of water vapor transmission rates of laminate bodies which are realized based on the above embodiments and include the overcoat layer (OC layer), some examples will be described. These experimental results of the respective examples are in regard to the gas barrier properties of the laminate body realized by the above embodiments and are obtained by measuring a water vapor transmission rate in an atmosphere of 40°C/90% RH using a water vapor transmission analyzer (MOCON Aquatran (registered trademark) manufactured by Modem Controls, Inc.). FIG. 3 is a view comparing a laminate body with an overcoat layer of the present example with a laminate body without an overcoat layer of a comparative example in terms of a Water Vapor Transmission Rate (WVTR). Accordingly, the superiority of the respective examples will be described with reference to FIG. 3.

### <Example 1>

As shown in FIG. 3, in Example 1, a UC layer is not formed on a polymeric base material of polyethylene terephthalate (PET) having a thickness of 100 µm, and a thin AlOₓ film as an ALD film is directly formed on the substrate. For the thin AlOₓ film (ALD film), tetramethyl aluminum (TMA) is used as raw material, and plasma treatment is performed to yield a film thickness of 10 nm.

On the surface of the ALD film, an OC layer is formed using an organic-inorganic composite coating film. The raw materials of the OC layer (organic-inorganic composite coating film) used at this time are hydrolyzed tetraethoxysilane (TEOS) and polyvinyl alcohol (PVA), and a compositional ratio between SiO₂ and PVA is 70%:30%. For the OC layer, a solution with a 5% solid content is prepared as a coating agent, and under processing conditions of 120°C-1 min, a film thickness of 0.5 µm is obtained by bar coating.

Using the sample of the laminate body of Example 1 formed as above, the gas barrier properties were measured. As a result, the initially measured value of Water Vapor Transmission Rate (WVTR) was 7.5 × 10⁻³ [g/m²/day], and the WVTR measured after a thermal shock test was 9.8 × 10⁻³ [g/m²/day]. That is, after the thermal shock test was performed on the laminate body of Example 1, the WVTR thereof increased by about 30%. The thermal shock test is a cold-heat shock test (based on JIS C 0025) and was performed under the conditions of -30°C (30 min)/85°C (30 min) for 50 cycles. The thermal shock test of the examples and comparative examples, which will be described later, was performed under the same conditions.

### <Example 2>

As shown in FIG. 3, in Example 2, a UC layer is formed on a polymeric base material of PET having a thickness of 100 µm using a urethane-based coating agent. For the urethane-based coating agent of the UC layer, a commercially available acrylic polyol, a 2-hydroxymethyl methacrylate (HEMA)/methyl methacrylate (MMA)-based copolymer, 30 mol% of HAMA having a molecular weight of 10,000, and a toluene diisocyanate (TDI) adduct-based curing agent are used as raw materials. The compositional ratio between the raw materials is NCO/OH = 0.5. For the UC layer, a solution with a 3% solid content is prepared as a coating agent, and under processing conditions of 120°C-1 min, a film thickness of 0.1 µm is obtained by bar coating.

Subsequently, as an ALD film on the UC layer, a thin AlOₓ film is formed. For the thin AlOₓ film, TMA is used as a raw material, and plasma treatment is performed to obtain a film thickness of 10 nm.

Moreover, on the surface of the ALD film, an OC layer is formed using an organic-inorganic composite coating film. At this time, as raw materials of the OC layer (organic-inorganic composite coating film), hydrolyzed TEOS, a silane compound, and PVA are used. The compositional ratio between SiO₂ and PVA is 85%:15%. For the OC layer, a solution with a 5% solid content is prepared as a coating agent, and under processing conditions of 120°C-1 min, a film thickness of 0.5 µm is obtained by bar coating.

Using the sample of the laminate body of Example 2 formed as above, the gas barrier properties were measured. As a result, the initially measured value of the WVTR was 3.1 × 10⁻³ [g/m²/day], and the WVTR measured after a thermal shock test was 6.4 × 10⁻³ [g/m²/day]. That is, after the thermal shock test was performed on the laminate body of Example 2, the WVTR thereof almost doubled.

### <Example 3>

As shown in FIG. 3, in Example 3, on a polymeric base material of PET having a thickness of 100 µm, a UC layer is formed using an inorganic substance-including urethane-based coating agent. For the urethane-based coating agent of the UC layer, a commercially available acrylic polyol, a HEMA/MMA-based copolymer, 30 mol% of HAMA having a molecular weight of 10,000, a TDI adduct-based curing agent, and an organic bentonite are used as raw materials. Moreover, the compositional ratio between the raw materials is NCO/OH = 0.5, and the content of the inorganic substance is 15 wt%. For the UC layer, a solution with a 3% solid content is prepared as a coating agent, and under processing conditions of 120°C-1 min, a film thickness of 1 µm is obtained by bar coating.

Thereafter, as an ALD film on the UC layer, a thin AlOₓ film is formed. For the thin AlOₓ film (ALD film), TMA is used as a raw material, and plasma treatment is performed to obtain a film thickness of 10 nm.

Moreover, on the surface of the ALD film, an OC layer is formed using an organic-inorganic composite coating film. At this time, as raw materials of the OC layer (organic-inorganic composite coating film), hydrolyzed TEOS, a silane compound, PVA, and an organic bentonite having an average particle diameter of 0.5 µm are used. The compositional ratio between SiO₂ and PVA is 85%:15%. For the OC layer, a solution with a 5% solid content is prepared as a coating agent, and under processing conditions of 120°C-1 min, a film thickness of 0.5 µm is obtained by bar coating.

Using the sample of the laminate body of Example 3 formed as above, the gas barrier properties were measured. As a result, the initially measured value of the WVTR was 0.8 × 10⁻³ [g/m²/day], and the WVTR measured after a thermal shock test was 2.1 × 10⁻³ [g/m²/day]. That is, after the thermal shock test was performed on the laminate body of Example 3, the WVTR thereof increased by about 2.5-fold.

### <Example 4>

As shown in Example 4 of FIG. 3, in Example 4, a UC layer is formed on a polymeric base material of PET having a thickness of 100 µm using an inorganic substance-including urethane-based coating agent. For the inorganic substance-including urethane-based coating agent of the UC layer, a commercially available acrylic polyol, a HEMA/MMA-based copolymer, 30 mol% of HAMA having a molecular weight of 10,000, a TDI adduct-based curing agent, and an ultrafine TiO₂ particle sol are used as raw materials. The compositional ratio between the raw material is NCO/OH = 0.5, and the content of the inorganic substance is 30 wt%. For the UC layer, a solution with a 3% solid content is prepared as a coating agent, and under processing conditions of 120°C-1 min, a film thickness of 0.1 µm is obtained by bar coating.

Thereafter, as an ALD film on the UC layer, a thin TiO_{X} film is formed. For the thin TiO_{X} film (ALD film), TiCl₄ is used as a raw material, and plasma treatment is performed to obtain a film thickness of 10 nm.

Moreover, on the surface of the ALD film, an OC layer was formed using an organic-inorganic composite coating film. At this time, as raw materials of the OC layer (organic-inorganic composite coating film), hydrolyzed TEOS, a silane compound, PVA, and ultrafine TiO₂ particles having an average particle diameter of 20 nm are used. The compositional ratio between SiO₂ and PVA is 85%:15%. For the OC layer, a solution with a 5% solid content is prepared as a coating agent, and under processing conditions of 120°C-1 min, a film thickness of 0.5 µm is obtained by bar coating.

Using the sample of the laminate body of Example 4 formed as above, the gas barrier properties were measured. As a result, the initial measurement value of the WVTR was 1.9 × 10⁻³ [g/m²/day], and the WVTR measured after a thermal shock test was 2.1 × 10⁻³ [g/m²/day]. That is, after the thermal shock test was performed on the laminate body of Example 4, the WVTR thereof increased by about 10%.

### «Comparative Examples»

Next, in order to demonstrate the superiority in the water vapor transmission rate of the laminate body including the OC layer according to the present example, the laminate body will be compared with comparative examples shown in FIG. 3.

### <Comparative Example 1>

As shown in FIG. 3, in Comparative Example 1, a stretched PET film (having a thickness of 100 µm) is prepared as a polymeric base material. On the surface of this base material, an AlOₓ film as an ALD film is formed instead of a UC layer. For the AlO_{X} film, TMA is used as a raw material, and plasma treatment is performed to obtain a film thickness of 10 nm. Moreover, an OC layer is not formed on the surface of the ALD film.

Using the sample of the laminate body of Comparative Example 1 formed as above, the gas barrier properties were measured. As a result, the initially measured value of the WVTR was 8.5 × 10⁻³ [g/m²/day], and the WVTR measured after a thermal shock test was 120.2 × 10⁻³ [g/m²/day]. That is, after the thermal shock test was performed on the laminate body of Comparative Example 1, the WVTR thereof increased by 14-fold or more.

### <Comparative Example 2>

As shown in Comparative Example 2 of FIG. 3, in Comparative Example 2, a stretched PET film (having a thickness of 100 µm) of PET is prepared as a polymeric base material. Moreover, similarly to Example 2, a UC layer is formed on the PET base material having a thickness of 100 µm using a urethane-based coating agent. For the urethane-based coating agent of the UC layer, a commercially available acrylic polyol, a HEMA/MMA-based copolymer, 30 mol% of HAMA having a molecular weight of 10,000, and a TDI adduct-based curing agent are used as raw materials. The compositional ratio between the raw materials is NCO/OH = 0.5. For the UC layer, a solution with a 3% solid content is prepared as a coating agent, and under processing conditions of 120°C-1 min, a film thickness of 0.1 µm is obtained by bar coating.

Thereafter, as an ALD film on the UC layer, a thin TiO_{X} film is formed. For the thin TiO_{X} film (ALD film), TiCl₄ is used as a raw material, and plasma treatment is performed to obtain film a thickness of 10 nm. An OC layer is not formed on the surface of the ALD film.

Using the sample of the laminate body of Comparative Example 2 formed as above, the gas barrier properties were measured. As a result, the initially measured value of the WVTR was 4.1 × 10⁻³ [g/m²/day], and the WVTR measured after a thermal shock test was 80.4 × 10⁻³ [g/m²/day]. That is, after the thermal shock test was performed on the laminate body of Comparative Example 2, the WVTR thereof increased by about 20-fold.

### <Review>

That is, regarding the gas barrier properties of the laminate body having an OC layer as in Examples 1 to 4, the value of the Water Vapor Transmission Rate (WVTR) measured after the thermal shock test increased little, compared to the initial value of the WVTR. On the other hand, regarding the gas barrier properties of the laminate body not having an OC layer as in Comparative Examples 1 and 2, the value of WVTR measured after the thermal shock test increased by a single digit or more (10-fold or more), compared to the initial value of the WVTR. It is considered that this is because the samples of the laminate body of Comparative Examples 1 and 2 do not have an OC layer on the surface of the ALD film, and accordingly, through-holes are formed in the ALD film due to heat stress or the like, whereby the gas barrier properties markedly deteriorate. On the other hand, it is considered that since the samples of the laminate body of Examples 1 to 4 are protected from external stress by being provided with on OC layer on the surface of the ALD film, the ALD film is not scratched by heat stress or the like, and accordingly, the gas barrier properties of the laminate bodies do not deteriorate.

### <Summary>

As described above, according to the laminate body of the present invention, an OC layer is disposed on the surface of an ALD film formed on a polymeric base material. Therefore, the OC layer is not scratched by stress caused by environmental change or a mechanical external force, hence the gas barrier properties of the laminate body can be improved. In addition, even if the ALD film is thin, the OC layer prevents this film from being scratched by an external force, and accordingly, desired performance can be realized even if the thickness of the ALD film is small.

So far, embodiments of the laminate body according to the present invention have been described in detail with reference to the drawings. However, the specific constitution of the present invention is not limited to the embodiments described above. Even if alterations and the like are made in the design within a range that does not depart from the gist of the present invention, they are also included in the present invention. Moreover, the present invention is also applied to a gas barrier film which is obtained by forming the laminate body realized by the above invention into a film shape.

### «Embodiments of method of manufacturing laminate body»

In the method of manufacturing a laminate body according to the embodiment of the present invention, in a first step, an atomic layer deposition film having a thin film shape is formed along the outer surface of a base material. Thereafter, in the next in-line step, an overcoat layer is formed on the surface of the atomic layer deposition film before the atomic layer deposition film comes into contact with a rigid substance such as a roller. Specifically, the base material on which the atomic layer deposition film has been formed is usually transported to the next step by being wound in a roll shape. However, in the present embodiment, before a roller for changing a travelling direction, which is for changing the travelling direction of the base material such that the base material on which the atomic layer deposition film has been formed becomes a roll shape, comes into contact with the atomic layer deposition film, the overcoat layer is formed on the surface of the atomic layer deposition film. It is desirable that during the manufacturing process of a laminate body, the overcoat layer be formed on the surface of the atomic layer deposition film, before the shape of the base material on which the atomic layer deposition film has been formed changes from the shape at the time of formation of the atomic layer deposition film. In this manner, it is possible to prevent the atomic layer deposition film from being scratched due to deformation of the base material and to maintain excellent gas barrier properties.

The overcoat layer needs to be a film having a mechanical strength higher than that of the atomic layer deposition film. Alternatively, when the mechanical strength of the overcoat layer is equivalent to that of the atomic layer deposition film, the overcoat layer needs to be a layer having a film thickness greater than that of the atomic layer deposition film. This is because even if the atomic layer deposition film is scratched by an external force, and through-holes are formed in the film thickness direction thereof, such an external force does not make through-holes in the overcoat layer in the film thickness direction thereof, and accordingly, the gas barrier properties of the laminate body can be excellently maintained. Moreover, an undercoat layer may or may not be formed between the base material and the atomic layer deposition film.

The method of manufacturing a laminate body according to the embodiment of the present invention is implemented by a laminate body manufacturing apparatus including an in-line overcoat formation portion in which the ALD film 4 and the OC layer 5 are formed by in-line serial steps. At this time, the method of manufacturing a laminate body according to the present embodiment can be applied to both the laminate body 1a in which the UC layer is not formed as shown in FIG. 1 and the laminate body 1b in which the UC layer 3 is formed as shown in FIG. 2. That is, regardless of the presence or absence of the UC layer, the method can be applied to the manufacturing process of the laminate bodies 1a and 1b, in which the thin film as the ALD film 4 is deposited by a roll-to-roll method onto a base material in a state of being wound (film shape) when the ALD film 4 and the OC layer (protective coat) 5 are formed by in-line steps.

Generally, the ALD film 4 formed (deposited) on the base material 2 is a dense and thin film, and even if the film thickness thereof is very small (for example, 10 nm), this film can exhibit excellent gas barrier properties. However, since the thickness of the ALD film 4 is small, when the thin film is deposited (formed) by ALD by means of a roll-to-roll method, the laminate body 1 (1a or 1b) in which the ALD film 4 has been formed may be scratched or obtain pinholes, due to the contact between this film and a guide roll or the like of a transport system, the contact between base materials caused when these substrates are wound up, and the like. If scratches or pinholes are caused in the ALD film 4 in this way, the gas barrier properties of the laminate body 1 deteriorate.

The minute defectiveness caused in the ALD film 4 is practically unproblematic when the laminate body 1 is required to have a low degree of gas barrier properties (for example, when the Water Vapor Transmission Rate (WVTR) is about 1.0 g/m²/day). However, when the laminate body 1 is required to have a high degree of gas barrier properties such as a WVTR of 1 × 10⁻³ g/m²/day or lower, the defectiveness causes problems in air-tightness.

For example, when the surface of the ALD film 4 is observed with an optical microscope before and after the laminate body 1 in which the ALD film 4 has been formed is brought into contact with (wound up around) a guide roller, scratches are not seen in the ALD film 4 before the laminate body 1 is brought into contact with the guide roller, but after the laminate body 1 is brought into contact with the guide roller, it is found that a large number of scratches are caused in the ALD film 4. If the surface of the ALD film 4 is treated with H₂SO₄ (sulfuric acid), the base material 2 (for example, PET: polyethylene terephthalate) under the scratches is dissolved, and in this manner, those scratches can be easily observed. That is, when the laminate body 1 in which the ALD film 4 has been formed is wound up once around the guide roller, the WVTR may increase to 1 × 10⁻³ g/m²/day or a higher rate.

Therefore, in order to prevent scratches or pinholes (through-holes) of the ALD film 4 that are caused by the contact between the guide roll and the laminate body 1, the contact between the laminate bodies 1 that is caused when the laminate body 1 is wound up, and the like, the film of the overcoat layer (OC layer) 5 as a protective coat is formed before the laminate body 1 comes into contact with the guide roller, by the in-line step performed immediately after the ALD film 4 is formed.

At this time, an organic polymer is desirable as the material of the OC layer 5, and examples thereof include acrylic ester monomers, mixtures of acrylic monomers and acrylic ester oligomers, and the like. The thickness of the OC layer 5 as a protective layer is desirably 1 µm or more. Moreover, the method of forming the protective coat film on the surface of the ALD film 4 using the OC layer 5 is implemented by a method in which parts of the machine do not come into direct contact with the surface of the ALD film 4.

The formation of the protective coat film using the OC layer 5 is performed by a process that is in line with the formation of the ALD film 4. Accordingly, the protective coat film and the ALD film 4 should be formed at the same coating speed within the same optimum range of a vacuum degree. In addition, when the protective coat is formed using the OC layer 5, if the protective coat comes into contact with the coat surface of the ALD film 4, this is not desirable since pinholes or scratches are caused. Therefore, a method by which the protective coat using the OC layer 5 can be formed in a non-contact manner is desirable.

When the ALD film 4 is formed in a vacuum, in order to maintain a desired vacuum degree, the process of forming the protective coat using the OC layer 5 should not generate a large amount of gas. From the above point of view, as the process of forming the protective coat film using the OC layer 5, Vapor Deposition by flash evaporation which is performed by a vacuum process in a non-contact manner and does not use a solvent for the coating agent (that is, a small amount of volatile gas is generated) is appropriate.

### <Third Embodiment: Formation of OC Layer by Vapor Deposition by flash evaporation>

In the third embodiment, a method of manufacturing a laminate body that forms the OC layer by Vapor Deposition by flash evaporation will be described. Vapor Deposition by flash evaporation is means for coating a monomer, an oligomer, and the like at a desired thickness in a vacuum. This method makes it possible to deposit an acryl layer onto a base material in a non-contact manner in a vacuum under a low heat load, without generating a large amount of volatile component such as a solvent. At this time, acrylic monomers, acrylic oligomers, and the like that remain liquid at room temperature and do not include a solvent are used.

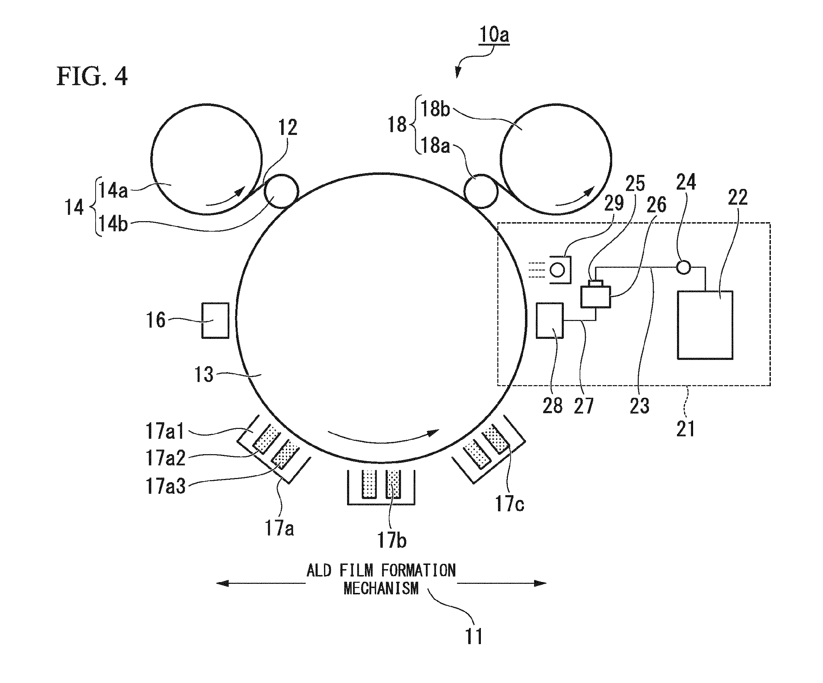

FIG. 4 is a schematic structural view of a laminate body manufacturing apparatus 10a which is applied to the third embodiment of the present invention and forms an OC layer by Vapor Deposition by flash evaporation. The laminate body manufacturing apparatus 10a is constituted of an ALD film formation mechanism 11 that forms the ALD film 4, an overcoat formation portion 21 that is disposed at the downstream side of the ALD film formation mechanism 11 and forms the OC layer 5 on the surface of the ALD film 4, a drum 13, and various rollers (a winding-off roller 14a, a winding-up roller 18b, and the like).

The constituents including the ALD film formation mechanism 11, the drum 13, and various rollers are configured as follows. That is, the constituents include the drum (support) 13 that supports one surface of a long windable web-like base material 12 formed into a thin plate, a film, or a membrane, in the thickness direction of the substrate; a transport mechanism 14 that includes the winding-off roller 14a and a small roller 14b transporting the base material 12 in one direction along the drum 13; a plasma pretreatment portion 16 that performs plasma pretreatment on the base material 12; ALD film formation portions 17a, 17b, and 17c that are disposed so as to make the base material 12 inserted between these portions and the surface of the drum 13 and attach the precursors of the ALD film onto the other surface of the base material 12 in the thickness direction of the substrate; and a winding-up mechanism 18 including a dancer roller 18a and a winding-up roller 18b that are disposed downstream of the overcoat formation portion 21 in the transport direction of the base material 12 and wind up the base material 12, on which the ALD film 4 and the OC layer 5 have been formed, in a roll shape.

The dancer roller 18a of the winding-up mechanism 18 has a function of applying a preset tension when the base material 12 is wound around the winding-up roller 18b. FIG. 4 shows three ALD film formation portions 17a, 17b, and 17c, but actually, the number of these portions to be provided needs to correspond to the film formation cycle of ALD that can realize a desired film thickness for the ALD film 4. For example, if 70 cycles are required as the film formation cycle of ALD for forming the ALD film 4 having a film thickness of 10 nm, 70 ALD film formation portions need to be provided. Moreover, the winding-off roller 14a, the drum 13, and the winding-up roller 18b rotate in the direction (counter clockwise direction) indicated by arrows of FIG. 4.

The overcoat formation portion 21 that forms (coats) the OC layer 5 on the surface of the ALD film 4 is constituted of a raw material tank 22, a raw material pipe 23, a raw material transport pump 24, an atomizer (sprayer) 25, a carburetor (evaporator) 26, a gas pipe 27, a coating nozzle 28, and an irradiation portion 29 that irradiates electron beams or ultraviolet (UV) rays to crosslink or cure the OC layer 5 (acryl layer) coated onto the surface of the ALD film 4.

The drum (support) 13 supports the base material 12 such that the base material 12 maintains a certain shape between the ALD film formation portions 17a, 17b, and 17c and the winding-up mechanism 18. As a result, the OC layer 5 is uniformly coated onto the surface of the ALD film 4.

Next, the operation for forming the OC layer 5 by means of Vapor Deposition by flash evaporation using the laminate body manufacturing apparatus 10a shown in FIG. 4 will be described. First, in the ALD film formation mechanism 11, the ALD film 4 is formed on the base material 2 by a general ALD process. Herein, a case where a thin ALD film 4 formed of aluminum oxide (Al₂O₃) is formed on the polymeric base material 2 by ALD employing a winding-up method will be described.

First, in Step 1, as a film-like polymeric base material 2, a stretched polyethylene terephthalate (PET) film having a thickness of 100 µm is wound up and then wound around the winding-off roller 14a of the transport mechanism 14 in the laminate body manufacturing apparatus 10.

Thereafter, in Step 2, while being supported from the rear surface by the drum (support) 13, the film-like base material 12 wound off from the small roller 14b as a winding-off axis of the transport mechanism 14 is exposed to an oxygen plasma atmosphere in the plasma pretreatment portion 16 such that the substrate surface is modified. At this time, the conditions of the plasma treatment are appropriately selected according to the properties of the base material 12.

Subsequently, in Step 3, after the plasma treatment is completed, the base material 12 moves to a purging area 17a1 of the ALD film formation portion 17a of the ALD film formation mechanism 11 that is in an inert gas (nitrogen gas) atmosphere.

Then in Step 4, the base material 12 enters the zone of the ALD film formation portion 17a and passes through the purging area 17a1. Thereafter, trimethylaluminum is adsorbed onto the substrate in the atmosphere of a first precursor area 17a2. The first precursor area 17a2 is kept at a pressure of about 10 Pa to 50 Pa and an inner wall temperature of about 70°C in the atmosphere of nitrogen gas and trimethylaluminum.

Next, in Step 5, the base material 12 moves to the purging area 17a1 of the next section, and in the atmosphere thereof, the surplus first precursors are removed.

In Step 6, the base material 12 then moves to a second precursor area 17a3 from the purging area 17a1. The second precursor area 17a3 is kept at a pressure of about 10 to 50 Pa and an inner wall temperature of about 70°C in the atmosphere of nitrogen gas and water. In the second precursor area 17a3, water reacts with the trimethylaluminum having been adsorbed onto the base material 12.

Subsequently, in Step 7, the base material 12 passes through a slit (not shown in the drawing) which is in a divider plate disposed between the second precursor area 17a3 and the purging area 17a1 and is transported to the next purging area 17a1. In the purging area 17a1, the surplus second precursors are removed.

The ALD film 4 formation treatment consisting of Steps 1 to 7 as above forms one cycle, whereby the ALD film 4 as one layer of a laminate body is formed on the surface of the base material 12. FIG. 4 shows three cycles performed by three ALD film formation portions 17a, 17b, and 17c. However, actually, the film formation treatment is performed for 70 cycles by 70 ALD film formation portions 17, and a thin aluminum oxide (Al₂O₃) film of about 10 nm is formed as the ALD film 4 on the surface of the base material 12.

The base material 12, on which the thin aluminum oxide (Al₂O₃) film as the ALD film 4 has been formed by the ALD film formation portions 17a, 17b, and 17c, is transported to the overcoat formation portion 21 that forms the OC layer 5 as a protective coat.

In Vapor Deposition by flash evaporation performed in the overcoat formation portion 21, a coat material (acrylic monomer or the like), which is sent out to the raw material pipe 23 from the raw material tank 22 by the raw material transport pump 24, is added dropwise to the atomizer (sprayer) 25. The coat material (acrylic monomer or the like) having been added dropwise to the atomizer (sprayer) 25 turns into gas as soon as it comes into contact with the wall surface of the carburetor (evaporator) 26.

Thereafter, the coat material having turned into gas (gaseous state) in the carburetor 26 passes through the gas pipe 27 kept at a high temperature and diffuses to the coating nozzle 28. The gaseous coat material flowing out of the coating nozzle 28 by spraying is then aggregated on the surface of the base material 12. Subsequently, the OC layer 5 formed of the coat material having been aggregated on the surface of the base material 12 is crosslinked and cured by electron beams or UV rays irradiated from the irradiation portion 29. The coating section (overcoat formation portion 21) of the OC layer 5 is usually kept in the atmosphere of inert gas such as nitrogen gas so as not to hinder the crosslinking of the coat material.

The coating thickness of the OC layer 5 can be optionally adjusted by regulating the amount of the coat material that is added dropwise to the carburetor 26 per unit time. For example, when it is desired to form the OC layer 5 with a large coating film thickness, the amount of the coat material added dropwise to the carburetor 26 is increased, and when it is desired to form the OC layer 5 with a small coating film thickness, the amount of the coat material added dropwise to the carburetor 26 is reduced. In this manner, it is possible to control the uniformity of the coating film thickness of the OC layer 5 by maintaining the amount of the material added dropwise per unit time at a constant level.

That is, the base material 12, on which the thin ALD film 4 has been formed of aluminum oxide (Al₂O₃) in the ALD film formation mechanism 11, is transported to the overcoat formation portion 21 for forming a protective coat (OC layer 5), without being brought into contact with the parts and the like of the machine on the way to the overcoat formation portion 21. Meanwhile, in the overcoat formation portion 21, an acrylic coating agent (for example, an acrylic monomer, an oligomer, or a photoinitiator) is emitted from the coating nozzle 28 in the form of vapor. Accordingly, when the base material 12 on which the ALD film 4 has been formed of aluminum oxide (Al₂O₃) passes through the coating nozzle 28, the OC layer 5 formed of the acrylic coating agent is aggregated on the surface of the thin aluminum oxide (Al₂O₃) film.

Subsequently, the base-material film (laminate body 1), in which the OC layer 5 of the acrylic coating agent has been deposited onto the surface of the thin aluminum oxide (Al₂O₃) film (ALD film 4), is transported to an irradiation zone (irradiation portion 29) of a UV lamp or electron beams in the irradiation portion 29. At this time, when the base-material film (laminate body 1) passes through the irradiation portion 29 that irradiates UV rays or electron beams, the acrylic coating agent is cured, whereby the OC layer 5 of about 1 µm is formed.

The base-material film (laminate body 1) on which the OC layer 5 has been formed by Vapor Deposition by flash evaporation in this manner is transported to the winding-up mechanism 18 and is wound around the winding-up roller 18b while being applied with a certain degree of tension by the dancer roller 18a. Therefore, the thin aluminum oxide (Al₂O₃) film (ALD film 4) does not come into direct contact with the winding-up mechanism 18 (the dancer roller 18a or the winding-up roller 18b). Moreover, even after the base-material film (laminate body 1) is wound around the winding-up roller 18b, the thin aluminum oxide (Al₂O₃) films (ALD films 4) may not come into direct contact with each other. As a result, pinholes or scratches may not be formed in the ALD film 4 of the base-material film (laminate body 1) having been wound around the winding-up roller 18b, hence the high-quality laminate body 1 can be produced in a state of being wound up.

### <Fourth Embodiment: Formation of OC Layer by CVD>

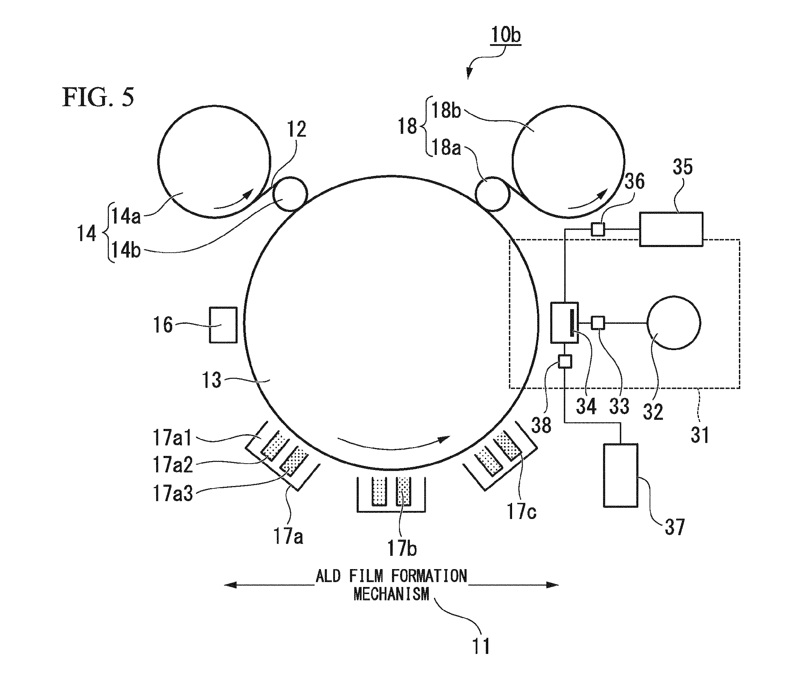

In the fourth embodiment, a method of manufacturing a laminate body that forms the OC layer by CVD, that is, chemical vapor deposition will be described. FIG. 5 is a schematic structural view of a laminate body manufacturing apparatus 10b which is applied to the fourth embodiment of the present invention and forms an overcoat layer by CVD. Since the structure including the ALD film formation mechanism 11 forming the ALD film 4 on the base material 12, the drum 13, and various rollers is the same as that of FIG. 4, detailed description thereof will not be repeated.

An overcoat formation portion 31 is constituted of a Radio Frequency (RF: high frequency) power source 32 that supplies high-frequency power for plasma of, for example 13.56 MHz; a matching box 33 that matches the frequency of the high-frequency power for plasma; electrodes 34 for plasma discharge that are for performing chemical vapor deposition; a gas tank 35 that supplies gas such as ozone or O₂; an atmospheric gas flow meter 36 that measures the amount of the supplied atmospheric gas such as ozone or O₂; a raw material tank 37 that supplies fluorocarbon gas such as Hexamethyldisioxane (HMDSO) for CVD; and a raw material gas flow meter 38 that measures the amount of the supplied fluorocarbon gas such as HMDSO.

Next, the operation for forming the OC layer 5 by means of CVD using the laminate body manufacturing apparatus 10b shown in FIG. 5 will be described. First, in the same manner as the Vapor Deposition by flash evaporation described above in the third embodiment, by a general ALD process, the ALD film 4 formed of an Al₂O₃ film having a thickness of 10 nm is formed on the surface of the polymeric base material 12 in the ALD film formation mechanism 11.

The base material 12, on which the thin Al₂O₃ film (ALD film 4) has been formed in the ALD film formation portions 17a, 17b, and 17c, moves to the overcoat formation portion 31 in the same manner as in the case described in the third embodiment. Thereafter, when the base material 12 on which the thin Al₂O₃ film has been formed passes through the overcoat formation portion 31, a thin SiO₂ film having a thickness of 1 µm is formed by a general CVD process.

At this time, in the overcoat formation portion 31, 1.0 kW of high-frequency power having a frequency of 13.56 MHz is applied to the electrode 34 from the RF power source 32. Moreover, from the raw material tank 37, hexamethyldisiloxane (HMDSO) having a film formation pressure of 10 Pa is supplied. The amount of HMDSO supplied at this time is 100 sccm. In addition, the amount of ozone gas supplied from the gas tank 35 is 100 sccm. Meanwhile, the inter-electrode distance of the electrodes 34 of CVD is 30 mm. In addition, the base material 12 is formed of polyethylene terephthalate (PET) and has a thickness of 100 µm.

The base-material film (laminate body 1), on which the OC layer 5 has been formed by CVD as above, is transported to the winding-up mechanism 18 and wound around the winding-up roller 18b while being applied with a certain degree of tension by the dancer roller 18a. Therefore, the thin aluminum oxide (Al₂O₃) film (ALD film 4) does not come into direct contact with the winding-up mechanism 18 (the dancer roller 18a or the winding-up roller 18b). Moreover, even after the base-material film (laminate body 1) is wound around the winding-up roller 18b, the thin aluminum oxide (Al₂O₃) films (ALD films 4) may not come into direct contact with each other. As a result, pinholes or scratches may not be formed in the ALD film 4 of the base-material film (laminate body 1) having been wound around the winding-up roller 18b, hence the high-quality laminate body 1 can be produced in a state of being wound up.

### <Manufacturing Process of Laminate Body>

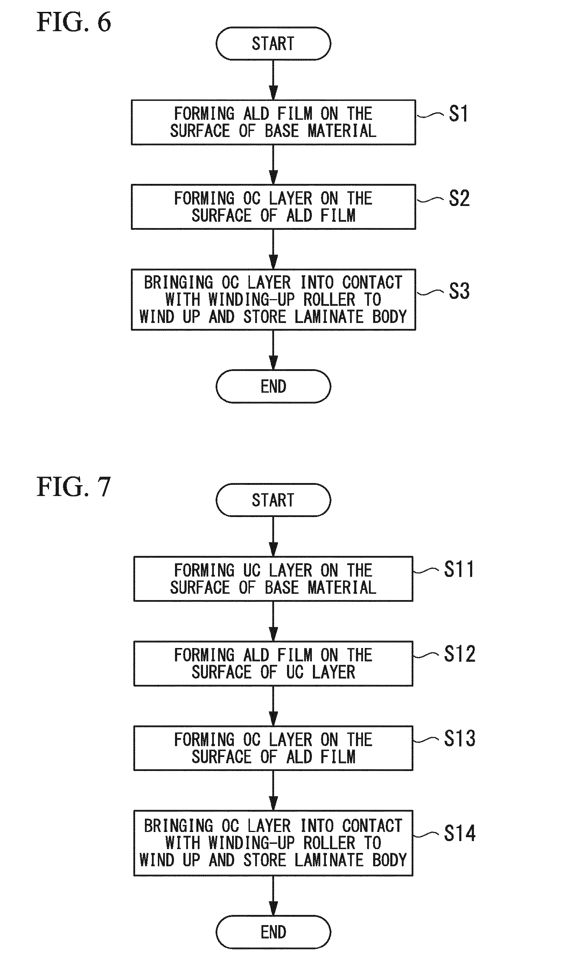

Based on the above, the manufacturing process of the laminate body 1 performed by the laminate body manufacturing apparatus 10a or 10b shown in FIG. 4 or 5 will be described. FIG. 6 is a flowchart illustrating a summary of a laminate body manufacturing process that is performed when the UC layer is not formed in the embodiment of the present invention. FIG. 7 is a flowchart illustrating a summary of a laminate manufacturing process that is performed when the UC layer is formed in the embodiment of the present invention.

First, referring to FIG. 6, the manufacturing process of the laminate body 1a that is performed when the UC layer is not formed will be described. Firstly, the ALD film 4 having a thin film shape is formed along the outer surface of the polymeric base material 2 (Step S1). Thereafter, in a line that is within the step serially connected to the formation of the ALD film 4, the OC layer 5 having a mechanical strength higher than that of the ALD film 4 is formed along the outer surface of the ALD film 4 to generate the laminate body 1a (Step S2). In the Step S2, the OC layer 5 which has a mechanical strength equivalent to that of the ALD film 4 and has a film thickness greater than that of the ALD film 4 may be formed along the outer surface of the ALD film 4 to generate a laminate body. Subsequently, the OC layer 5 is brought into contact with the winding-up roller 18b, whereby the laminate body 1a is wound up and stored (Step S3).

In this way, since the OC layer 5 having a mechanical strength higher than that of the ALD film 4 comes into contact with the dancer roller 18a or the winding-up roller 18b, the ALD film 4 does not come into direct contact with the dancer roller 18a or the winding-up roller 18b. Accordingly, the ALD film 4 may not be scratched. As a result, it is possible to cause the laminate body 1a to be wound around the winding-up roller 18b while maintaining the gas barrier properties of the laminate body 1a at an excellent level. Moreover, even when the mechanical strength of the OC layer 5 is equivalent to that of the ALD film 4, if the film thickness of the OC layer 5 is greater than that of the ALD film 4, through-holes may not be formed in the OC layer 5 even if an external force of such a degree that causes some scratches in the ALD film 4 is applied. Consequently, it is possible to maintain the gas barrier properties of the laminate body 1a at an excellent level.

Next, referring to FIG. 7, the manufacturing process of the laminate body 1b that is performed when the UC layer is formed will be described. First, the UC layer 3 that includes at least either an inorganic substance or an organic polymer is formed along the outer surface of the polymeric base material 2 (Step S 11). Thereafter, the ALD film 4 having a thin-film shape is formed on the surface of the UC layer 3 such that the ALD film 4 binds to at least either the inorganic substance or the organic polymer exposed on the surface of the UC layer 3 (Step S2). Then in a line that is within the step serially connected to the formation of the ALD film 4, the OC layer 5 having a mechanical strength higher than that of the ALD film 4 is formed along the outer surface of the ALD film 4 to generate the laminate body 1b (Step S3). In the Step S3, the OC layer 5 which has a mechanical strength equivalent to that of the ALD film 4 and has a film thickness greater than that of the ALD film 4 may be formed along the outer surface of the ALD film 4 to generate the laminate body 1b. Subsequently, the OC layer 5 is brought into contact with the winding-up roller 18b, whereby the laminate body 1b is wound up and stored (Step S4).

In this way, since the OC layer 5 having a mechanical strength higher than that of the ALD film 4 comes into contact with the dancer roller 18a or the winding-up roller 18b, the ALD film 4 does not come into direct contact with the dancer roller 18a or the winding-up roller 18b. Accordingly, the ALD film 4 may not be scratched. As a result, it is possible to maintain the gas barrier properties of the laminate body 1a at an excellent level. Moreover, even when the mechanical strength of the OC layer 5 is equivalent to that of the ALD film 4, if the film thickness of the OC layer 5 is greater than that of the ALD film 4, through-holes may not be formed in the OC layer 5 even if an external force of such a degree that causes some scratches in the ALD film 4 is applied. Consequently, it is possible to maintain the gas barrier properties of the laminate body 1a at an excellent level.

### «EXAMPLES»

### <Example 1>

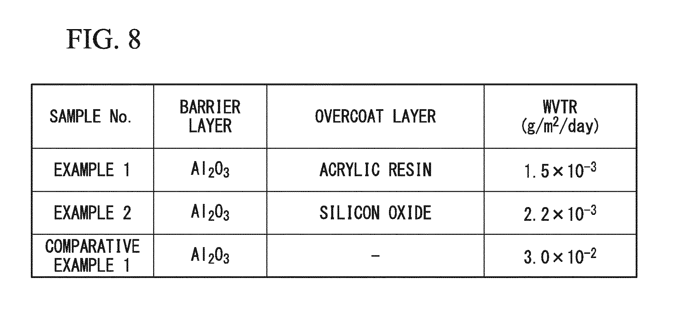

In Example 1, the OC layer is formed by means of Vapor Deposition by flash evaporation using the laminate body manufacturing apparatus 10a of FIG. 4. That is, as shown in FIG. 8, in Example 1, a stretched polyethylene terephthalate (PET) film having a thickness of 100 µm that is wound up as a film of a polymeric base material is wound around the winding-off roller 14a of the laminate body manufacturing apparatus 10a. Thereafter, the film (base material 12) wound off from the small roller 14b is exposed to an O₂ plasma atmosphere in the plasma treatment portion 16 under conditions of 300 W and 180 sec, whereby the film surface is modified. After the plasma treatment, the film is moved to the ALD film formation mechanism 11 of an N₂ gas atmosphere by the drum 13.

Subsequently, the film is introduced into the ALD film formation portion 17a and caused to pass through the purging area 17a1 in an atmosphere as a mixture of O₂ gas and N₂ gas. Thereafter, in the first precursor area 17a2 which is kept at an inner wall temperature of about 70°C and in an atmosphere as a mixture of of N₂ gas having a pressure of 10 to 50 Pa and trimethyl aluminum (TMA), TMA is adsorbed onto the surface of the film.

The film is then moved to the next purging area 17a1, and the surplus first precursors are removed in this area. Thereafter, the film is moved to the second precursor area 17a3 from the purging area 17a1. In the second precursor area 17a3 which is kept at an inner wall temperature of about 70°C and in an atmosphere of a mixture of N₂ gas having a pressure of 10 to 50 Pa and H₂O gas, H₂O is adsorbed onto the film. At this time, H₂O reacts with TMA, whereby aluminum oxide (Al₂O₃) is generated on the surface of the film.

Subsequently, the film is caused to pass through a slit in a divider plate disposed between the second precursor area 17a3 and the purging area 17a1 and transported to the next purging area 17a1. In this purging area 17a1, the surplus second precursors are removed.

The above operations constitute one cycle, and the film formation treatment is performed for 70 cycles in order of the ALD film formation portion 17a→the ALD film formation portion 17b→ the ALD film formation portion 17c, and the like. As a result, a thin aluminum oxide (Al₂O₃) film (barrier layer) of about 10 nm is formed on the surface of the film.

Thereafter, the film, on which the thin aluminum oxide (Al₂O₃) film has been formed by the ALD film formation mechanism 11, is transported to the overcoat formation portion 21. In the overcoat formation portion 21, an uncured coating film layer having a thickness of 1 µm that is formed of a mixture of 2-hydroxy-3-phenoxypropyl acrylate and propoxylated neopentylglycol diacrylate (mixing ration of 90/10 (wt%)) by means of Vapor Deposition by flash evaporation is laminated on the aluminum oxide (Al₂O₃) on the surface of the film.

Subsequently, the coating film layer formed by Vapor Deposition by flash evaporation is cured by being irradiated with electron beams from the irradiation portion 29, and an acryl coat layer (acrylic resin) having a thickness of 1 µm is formed as an overcoat layer (OC layer). The film, on which the OC layer has been formed by Vapor Deposition by flash evaporation, is then transported to the winding-up mechanism 18, and while being applied with a certain degree of tension by the dancer roller 18a, the film on which the OC layer has been formed is wound around the winding-up roller 18b.

Using the film (laminate body) sample of Example 1 formed as above, the gas barrier properties were measured. As a result, the value of the Water Vapor Transmission Rate (WVTR) thereof was found to be 1.5 × 10⁻³ [g/m²/day].

### <Example 2>

In Example 2, an OC layer is formed by means of CVD using the laminate body manufacturing apparatus 10b of FIG. 5. That is, as shown in FIG. 8, in Example 2, a thin aluminum oxide (Al₂O₃) film (barrier layer) of about 5 nm is formed on a stretched polyethylene terephthalate (PET) film having a thickness of 100 µm by the ALD film formation mechanism 11 in exactly the same manner as in Example 1.

Thereafter, the film, on which the thin aluminum oxide (Al₂O₃) film has been formed by the ALD film formation mechanism 11, is transported to the overcoat formation portion 31. In the overcoat formation portion 31, a mixed gas including 100 sccm of hexamethylene disiloxane (HMDSO) and 100 sccm of ozone is introduced between electrodes 34 of CVD, and 1.0 kW of high-frequency power having a frequency of 13.56 MHz is applied between the electrodes 34 from the RF power source 32 to create a plasma state. Subsequently, a silicon oxide film (SiO₂ film) of about 1 µm as an OC layer is formed on the aluminum oxide (Al₂O₃) on the surface of the film.

Then the film on which the OC layer has been formed by CVD is transported to the winding-up mechanism 18 and applied with a certain degree of tension by the dancer roller 18a, whereby the film is wound around the winding-up roller 18b.

Using the sample of the laminate body of Example 2 formed as above, the gas barrier properties were measured. As a result, the value of the Water Vapor Transmission Rate (WVTR) thereof was found to be 2.2 × 10⁻³ [g/m²/day].

### «Comparative Example»

Next, in order to demonstrate the superiority in the water vapor transmission rate of the laminate body including the OC layer according to the present example, the laminate body is compared with the comparative example shown in FIG. 8.

### <Comparative Example 1>

As shown in FIG. 8, in Comparative Example 1, a thin aluminum oxide (Al₂O₃) film (barrier layer) of about 5 nm is formed on a stretched polyethylene terephthalate (PET) film having a thickness of 100 µm by the ALD film formation mechanism 11 in exactly the same manner as in Example 1. Thereafter, in a state where the OC layer has not been formed, the film is transported to the winding-up mechanism 18. Then the film on which the OC layer has not been formed is applied with a certain degree of tension by the dancer roller 18a and wound around the winding-up roller 18b.

Using the sample of the laminate body of Comparative Example 1 formed as above, the gas barrier properties were measured. As a result, the value of the Water Vapor Transmission Rate (WVTR) thereof was found to be 3.0 × 10⁻² [g/m²/day]. That is, when the film (laminate body) not including the OC layer as in Comparative Example 1 was wound up by the winding-up mechanism 18, the WVTR was reduced by about one digit, compared to a case where the film (laminate body) including the OC layer as shown in Examples 1 and 2 is wound up by the winding-up mechanism 18. In other words, if the film (laminate body) not including the OC layer is wound up by the winding-up mechanism 18, the gas barrier properties markedly deteriorate.

### <<Summary>>

As described above, according to the present invention, the OC layer is disposed on the surface of the ALD film formed on a polymeric base material. Therefore, scratches or pinholes are not formed in the OC layer by a mechanical external force (stress) caused by a laminate body manufacturing apparatus using a roll-to-roll method, hence the gas barrier properties of the laminate body can be improved. As a result, it is possible to produce a high-quality film coated with the ALD film by a winding-up method at a high speed.

So far, the embodiments of the laminate body according to the present invention have been described in detail with reference to drawings. However, the specific constitution of the present invention is not limited to the contents of the embodiments described above, and if modification and the like are made to the design within a range that does not depart from the gist of the present invention, they are also included in the present invention. In the above embodiments, a method of manufacturing a laminate body and a laminate body manufacturing apparatus were described. However, needless to say, the present invention is not limited thereto and can be applied to a manufacturing method or a manufacturing apparatus of a gas barrier film obtained by forming a laminate body realized by the present invention into a film shape.

### INDUSTRIAL APPLICABILITY

The laminate body of the present invention of course can be used for electronic parts such as an electroluminescence device (EL device), a liquid crystal display, and a semiconductor wafer. Moreover, the laminate body can be effectively used for packing films of pharmaceutical products, foods, or the like, packing films of precision parts, and the like.

In addition, the present invention can be effectively used for semiconductor manufacturing apparatuses for manufacturing semiconductor parts such as an electroluminescence device (EL device), a liquid crystal display, and a semiconductor wafer, packing film manufacturing apparatuses for manufacturing packing films of pharmaceutical products, foods, precision parts, and the like.

### DESCRIPTION OF THE REFERENCE SYMBOLS

1a, 1b: laminate body
2, 12: base material
3: undercoat layer (UC layer)
4: atomic layer deposition film (ALD film)
5: overcoat layer (OC layer)
10a, 10b: laminate body manufacturing apparatus
11: ALD film formation mechanism
13: drum (support)
14: transport mechanism
14a: winding-off roller
14b: small roller
16: plasma pretreatment portion
17a, 17b, 17c: ALD film formation portions
17a1: purging area
17a2: first precursor area
17a3: second precursor area
18: winding-up mechanism
18a: dancer roller
18b: winding-up roller
21, 31: overcoat formation portion
22: raw material tank
23: raw material pipe
24: raw material transport pump
25: atomizer
26: carburetor
27: gas pipe
28: coating nozzle
29: irradiation portion
32: RF power source
33: matching box
34: electrode
35: gas tank
36: atmospheric gas flow meter
37: raw material tank
38: raw material gas flow meter

## Claims

1. A laminate body comprising:
a base material;
an atomic layer deposition film that is formed along the outer surface of the base material; and
an overcoat layer that covers the atomic layer deposition film with a film having a mechanical strength higher than that of the atomic layer deposition film.

2. A laminate body comprising:
a base material;
an atomic layer deposition film that is formed along the outer surface of the base material; and
an overcoat layer that covers the atomic layer deposition film with a film which has a mechanical strength equivalent to that of the atomic layer deposition film and has a film thickness greater than that of the atomic layer deposition film.

3. The laminate body according to Claim 1 or 2,
wherein the overcoat layer is formed of an aqueous barrier coat, and the aqueous barrier coat includes at least either an OH group or a COOH group.

4. The laminate body according to any one of Claims 1 to 3
wherein the overcoat layer includes an inorganic substance.

5. The laminate body according to any one of Claims 1 to 4, further comprising, between the base material and the atomic layer deposition film, an undercoat layer in which an inorganic substance binding to the atomic layer deposition film has dispersed or an undercoat layer which includes an organic polymer binding to the atomic layer deposition film.

6. A gas barrier film comprising the laminate body according to any one of Claims 1 to 5,
wherein the laminate body is formed into a film shape.

7. A method of manufacturing a laminate body, comprising:
a first step of forming an atomic layer deposition film having a thin film shape along the outer surface of a base material;
a second step of generating a laminate body by forming an overcoat layer which has a mechanical strength higher than that of the atomic layer deposition film along the outer surface of the atomic layer deposition film, in a line that is within the step serially connected to the first step; and
a third step of storing the laminate body such that the overcoat layer formed by the second step comes into contact with a rigid substance.

8. A method of manufacturing a laminate body, comprising:
a first step of forming an atomic layer deposition film having a thin film shape along the outer surface of a base material;
a second step of generating a laminate body by forming an overcoat layer along the outer surface of the atomic layer deposition film using a film which has a mechanical strength equivalent to that of the atomic layer deposition film and has a film thickness greater than that of the atomic layer deposition film, in a line that is within the step serially connected to the first step; and
a third step of storing the laminate body such that the overcoat layer formed by the second step comes into contact with a rigid substance.

9. A method of manufacturing a laminate body, comprising:
a first step of forming an undercoat layer that includes at least either an inorganic substance or an organic polymer, along the outer surface of a base material;
a second step of forming an atomic layer deposition film having a thin film shape on the outer surface of the undercoat layer such that the atomic layer deposition film binds to at least either the inorganic substance or the organic polymer exposed on the surface of the undercoat layer formed by the first step;
a third step of generating a laminate body by forming an overcoat layer which has a mechanical strength higher than that of the atomic layer deposition film along the outer surface of the atomic layer deposition film, in a line that is within the step serially connected to the second step; and
a fourth step of storing the laminate body such that the overcoat layer formed by the third step comes into contact with a rigid substance.

10. A method of manufacturing a laminate body, comprising:
a first step of forming an undercoat layer that includes at least either an inorganic substance or an organic polymer, along the outer surface of a base material;
a second step of forming an atomic layer deposition film having a thin film shape along the outer surface of the undercoat layer such that the atomic layer deposition film binds to at least either the inorganic substance or the organic polymer exposed on the surface of the undercoat layer formed by the first step;
a third step of generating a laminate body by forming an overcoat layer along the outer surface of the atomic layer deposition film using a film which has a mechanical strength equivalent to that of the atomic layer deposition film and has a film thickness greater than that of the atomic layer deposition film, in a line that is within the step serially connected to the second step; and
a fourth step of storing the laminate body such that the overcoat layer formed by the third step comes into contact with a rigid substance.

11. The method of manufacturing a laminate body according to any one of Claims 7 to 10,
wherein the rigid substance is a winding-up roller, and during or after the third step, the laminate body is stored by coming into contact with and being wound around the winding-up roller in a roll shape.

12. The method of manufacturing a laminate body according to any one of Claims 7 to 11,
wherein the overcoat layer is obtained by forming an acryl film on the outer surface of the atomic layer deposition film by Vapor Deposition by flash evaporation or is formed by chemical vapor deposition.

13. A laminate body manufacturing apparatus that transports a laminate body in which an atomic layer deposition film has been formed on a windable web-like base material formed into a thin plate, a film, or a membrane shape by a roll-to-roll method using in-line steps, the apparatus comprising:
a support that supports one surface of the base material in the thickness direction;
a transport mechanism that transports the base material in one direction along the outer surface of the support;
ALD film formation portions that are disposed such that the base material is inserted between these portions and the outer surface of the support and form the atomic layer deposition film on the other surface of the base material in the thickness direction;
an overcoat formation portion that is disposed downstream of the ALD film formation portions in the transport direction of the base material and forms an overcoat layer which has a mechanical strength higher than that of the atomic layer deposition film or has a film thickness greater than that of the atomic layer deposition film on the surface of the atomic layer deposition film; and
a winding-up mechanism that is disposed downstream from the overcoat formation portion in the transport direction of the base material and winds up the laminate body in a roll shape using the overcoat layer as a contact surface.

14. The laminate body manufacturing apparatus according to Claim 13,
wherein the overcoat formation portion forms the overcoat layer by Vapor Deposition by flash evaporation or chemical vapor deposition.

15. The laminate body manufacturing apparatus according to Claim 13 or 14, further comprising an undercoat formation portion that is disposed upstream from the ALD film formation portions in the transport direction of the base material,
wherein the undercoat formation portion forms an undercoat layer that has binding sites binding to the atomic layer deposition film, on the outer surface of the base material.
